# EUROPÄISCHE PATENTSCHRIFT

(11) **EP 2 835 042 B1**
(45) Veröffentlichungstag und Bekanntmachung des Hinweises auf die Patenterteilung: **19.10.2016**
(21) Anmeldenummer: 13713179.3
(22) Anmeldetag: 28.03.2013
(51) Int. Cl.: H05K 5/00

(54) **ERWEITERBARES GEHÄUSE FÜR ELEKTRISCHE BAUTEILE, ZWISCHENGEHÄUSETEIL FÜR DAS ERWEITERBARE GEHÄUSE, SOWIE VERFAHREN ZUR HERSTELLUNG UND ZUR MONTAGE DES GEHÄUSES**
EXTENDABLE HOUSING FOR ELECTRICAL COMPONENTS, INTERMEDIATE HOUSING PART FOR THE EXTENDABLE HOUSING, AND METHOD FOR PRODUCING AND FOR FITTING THE HOUSING
BOÎTIER EXTENSIBLE POUR COMPOSANTS ÉLECTRIQUES, INTERCALAIRE POUR LE BOÎTIER EXTENSIBLE, ET PROCÉDÉ DE FABRICATION ET DE MONTAGE DU BOÎTIER

(30) Priorität: 04.04.2012 DE 102012006787
(43) Veröffentlichungstag der Anmeldung: 11.02.2015
(73) Patentinhaber: Inter Control Hermann Köhler Elektrik GmbH & Co. KG, 90411 Nürnberg (DE)
(72) Erfinder: EMMERLING, Hans-Jürgen, 90411 Nürnberg (DE); KAISER, Hans-Dieter, 90411 Nürnberg (DE); RAFAEL, Norbert, 90411 Nürnberg (DE)
(74) Vertreter: Stippl, Hubert
(86) Internationale Anmeldenummer: PCT/EP2013/056731
(87) Internationale Veröffentlichungsnummer: WO 2013/149944

(56) Entgegenhaltungen:
- WO-A2-03/014877
- DE-A1- 10 013 134
- GB-A- 2 298 452

## Beschreibung

Die Erfindung betrifft eine Gehäuse-Vorrichtung zur Aufnahme von elektrisch kontaktierbaren Komponenten wie z.B. Leiterplatten, und ein Verfahren zur Montage der Gehäuse-Vorrichtung allein oder in Verbindung mit elektrisch kontaktierbaren Komponenten.

Es sind Gehäuse für Leiterplatten bekannt, welche eine Anordnung mehrerer Leiterplatten übereinander ermöglichen, und eine Kontaktierung der Leiterplatten z.B. über durch die Gehäusewandung geführte Anschlussbuchsen erlauben, so z.B. aus der Gebrauchsmusterschrift DE 20 2008 008 516 U1. Aus der DE 82 30 004 U1 oder der DE 7115847 U ist ferner bekannt, auf welche Weise mehrere Teile eines Gehäuses für elektronische Komponenten miteinander verbunden werden können, und wie solche Gehäuse dabei hinsichtlich Wärmeübertragungseigenschaften optimiert werden können. Ferner sind Gehäuse bekannt, welche Führungen zur Aufnahme von Leiterplatten aufweisen, in welche die Leiterplatten von einer Seite oder von gegenüberliegenden Seiten eingeschoben werden können.

Speziell zur Anordnung einer Vielzahl an Leiterplatten zeigt die Patentschrift DE 34 45 576 C2 ein Gehäuse mit Führungen zur planparallelen Anordnung der Leiterplatten, bei welchem die Leiterplatten mittels Führungsplatten ausgerichtet sind und eine Kontaktierung der Leiterplatten an einer Rückseite des Gehäuse ermöglicht ist.

Die Offenlegungsschrift DE 1 924 421 A zeigt ein Gehäuse aus zwei tiefgezogenen Teilen, in welchem Leiterplatten senkrecht zu einer Grundplatte angeordnet werden können durch Einsetzen in eine Steckerleiste, welche auf einer mit der Grundplatte verbindbaren Platte vorgesehen ist, und die Leiterplatten können über Führungen in der Grundplatte ausgerichtet und im Wesentlichen parallel zueinander angeordnet werden.

Die Patentschrift DE 42 31 827 C2 zeigt eine Möglichkeit zum Anordnen von Leiterplatten in einem Gehäuse durch einen Klemm-Mechanismus, bei welchem mehrere Keile mit den Rändern der Leiterplatten zusammenwirken und in Verbindung mit entsprechenden Führungsnuten eine Vielzahl an Leiterplatten übereinander angeordnet werden können.

Es besteht eine Aufgabe darin, ein Gehäuse derart bereitzustellen, dass in dem Gehäuse elektrisch kontaktierbare Bauteile auf einfache Weise angeordnet und befestigt werden können. Insbesondere stellt sich bei der vorliegenden Erfindung die Aufgabe, ein Gehäuse für eine oder mehrere Bauteile, insbesondere Leiterplatten, bereitzustellen, bei welchem die Bauteile unabhängig voneinander angeordnet werden können. Eine weitere Aufgabe besteht auch darin, ein Gehäuse bereitzustellen, welches sich in seiner Größe und seinen Abmessungen an die Anzahl der darin anzuordnenden Bauteile anpassen lässt. Ferner besteht auch eine Aufgabe darin, ein Gehäuse derart auszulegen, dass unabhängig von der Anzahl der darin anzuordnenden elektrisch kontaktierbaren Komponenten das Gehäuse auf einfache Weise montiert und wieder demontiert werden kann. Eine weitere Aufgabe besteht auch darin, ein flexibel verwendbares Gehäuse für den allen Umwelteinflüssen wie Temperaturschwankungen und Niederschlag ausgesetzten Außenbereich bereitzustellen, welches eine ausreichende Abdichtung gegenüber der Umgebung sicherstellen kann. Nicht zuletzt ist es auch eine Aufgabe, bei einem unabhängig von der Anzahl der in einem Gehäuse anzuordnenden elektrisch kontaktierbaren Komponenten bzw. Bauteile eine einfache Kontaktierung der Komponenten mit elektrischen Steckern zu ermöglichen, bei welcher auch eine Abdichtung des Gehäuses gegenüber der Umgebung sichergestellt werden kann.

Zumindest eine der voranstehenden Aufgaben wird durch ein Gehäuse gemäß Anspruch 1 gelöst.

Gemäß der Lehre des Anspruchs 1wird ein Gehäuse zur Aufnahme elektronischer Bauteile bereitgestellt, wobei das Gehäuse ein erstes und ein zweites Gehäuseteil aufweist, welche ein Gehäuseoberteil und ein Gehäuseunterteil mit jeweils einem Kuppelbereich bilden, und welche über ihren jeweiligen Kuppelbereich miteinander kuppelbar sind, wobei die Gehäuseteile jeweils eine Gehäusegrundfläche aufweisen und in einem zusammengebauten Zustand einen zur platzsparenden Umgrenzung der Bauteile ausgelegten Innenraum bilden, und wobei das Gehäuse Aufnahmemittel zur definierten Anordnung der Bauteile aufweist.

Erfindungsgemäß wird ferner vorgeschlagen, dass dabei jedes Gehäuseteil zur Aufnahme mindestens eines Bauteils vorgesehen ist, und dass in jedem Gehäuseteil Aufnahmemittel vorgesehen sind, und dass die Gehäuseteile jeweils im Kuppelbereich eine Aussparung in der vertikalen Außenwand des Gehäuseteils aufweisen, welche in einem zusammengebauten Zustand des Gehäuses zusammen mit dem Kuppelbereich eines benachbarten Gehäuseteils jeweils eine Durchführung von Innen nach Außen für einen elektrischen Stecker bildet, so dass in dem Gehäuse vorgesehene Bauteile über die Durchführungen jeweils separat elektrisch kontaktierbar sind.

Dadurch können bei dem Gehäuse platzsparend zwei Bauteile, insbesondere Leiterplatten, vorgesehen werden, und es wird ein in Bezug auf die aufzunehmenden Bauteile sehr kompaktes Gehäuse bereitgestellt. Durch die Anordnung der Bauteile bzw. Leiterplatten mit zueinander gewandten Oberseiten kann nahezu die Bauhöhe des einen der an einer Leiterplatte vorgesehenen (üblicherweise verlöteten) Stecker eingespart werden. Zudem können die Leiterplatten unabhängig voneinander angeordnet werden und kontaktiert werden, insbesondere auch jeweils direkt von außen. Die Gehäuseteile bilden somit in einem zusammengebauten Zustand zusammen Durchführungen für Stecker oder Leitungen zur Kontaktierung der Leiterplatten. Gemäß einem Ausführungsbeispiel können zwei benachbarte Gehäuseteile zusammen miteinander zwei Steckerdurchführungen bilden, so dass zwei Leiterplatten jeweils über einen eigenen (Zentral-)Stecker kontaktiert werden können. Zusätzlich zu diesen Durchführungen können auch weitere elektrische Verbindungen zwischen einem Gehäuseinnenraum und der Umgebung vorgesehen sein, z.B. zu dem Zweck, eine Trennung von Eingabe-/Ausgabe-Leitungen und Kommunikationsleitungen (BUS-Leitungen) sicherzustellen. Denn ein Anwendungsbereich für die erfindungsgemäßen Gehäuse liegt bei Hubarbeitsbühnen, Kränen, oder generell Arbeitsmaschinen mit elektrohydraulischen Komponenten, und es können sich Entfernungen zwischen einzelnen miteinander kommunizierenden Komponenten von über 100 Metern ergeben, was eine homogene BUS-Leitung für alle Komponenten vorteilhaft macht. Durch eine Trennung von BUS-Leitungen (z.B. vom Typ CAN) und Eingabe-/Ausgabe-Leitungen kann sowohl eine geringe Bauhöhe als auch eine einfach zugängliche Kontaktierung von BUS-Leitungen sichergestellt werden. Die BUS-Leitungen können z.B. über M12-Stecker an einem Boden oder Deckel des Gehäuses vorgesehen sein. Die Durchführungen für die (Zentral-)stecker können auch durch Blinddeckel oder Blindstecker geschlossen werden, falls nicht in allen Ebenen Bauteile vorgesehen werden sollen. Derartige Blinddeckel oder -stecker können z.B. aus demselben Material wie das Gehäuse bestehen. Sie können z.B. aus einem Kunststoffmaterial mit guten Abdicht- und/oder Dämmeigenschaften bestehen. Sie können an im Bereich der Schnittstelle zum Gehäuse dieselbe Geometrie aufweisen wie ein üblicherweise vorzusehender Stecker, so dass eine Abdichtung unabhängig davon möglich ist, ob eine elektrische Kontaktierung erfolgen soll oder nicht.

Eine elektrische Kontaktierung der Leiterplatten innerhalb des Gehäuses ist nicht notwendigerweise erforderlich, was metallische Kontakte oder Leitungen in dem Gehäuse entbehrlich macht, und wodurch das Gehäuse kostengünstig herstellbar wird. Gleichzeitig können die Leiterplatten im zusammengebauten Zustand des Gehäuses derart gegenüberliegend vorgesehen werden, dass sie mit ihrer Seite, auf welcher elektronische Bauteile vorgesehen sind, hier als Leiterplatten-Oberseite bezeichnet, zueinander gewandt angeordnet sind, und mit ihrer Unterseite an dem jeweiligen Gehäuseteil anliegen. Dies erleichtert einerseits die Montage einer jeden Leiterplatte in dem Gehäuse, denn jede Leiterplatte kann von oben in eines der schalenartigen Gehäuseteile eingesetzt werden, und andererseits können die Leiterplatten mit ihrer Unterseite unmittelbar an dem Gehäuse anliegend angeordnet werden, was einerseits Stabilität liefert, oder was andererseits auch im Hinblick auf eine Ableitung von Wärme von der Leiterplatte weg vorteilhaft sein kann, insbesondere in Verbindung mit irgendeiner Art Wärmeleitmedium zwischen Leiterplatte und Gehäusewandung. Es kann dadurch die Gefahr vermindert werden, dass sich das Gehäuseinnere nachteilig erwärmt, selbst wenn keine Lüfter oder dergleichen vorgesehen sind. Nicht zuletzt liefert diese Art der Gehäusekonstruktion mit durchgeführten Steckern die Möglichkeit, eine bei der Montage innerhalb des Gehäuses oder auch bereits während des Einsatzes des geschlossenen Gehäuses überhaupt noch nicht kontaktierte (und damit nicht verwendete) Leiterplatte elektrisch zu kontaktieren, ohne das Gehäuse öffnen zu müssen, oder aber eine Leiterplatte gar nicht mehr elektrisch zu kontaktieren und von dem Gesamtsystem anderer Leiterplatten zu entkoppeln, ohne sie aus dem Gehäuse entfernen zu müssen.

Ein erfindungsgemäßes Gehäuse kann standardgemäß für jeweils eine in einer bestimmten Ebene angeordnete Leiterplatte einer Vielzahl von Leiterplatten vorgesehen sein, also z.B. vier Leiterplatten in vier unterschiedlichen Leiterplattenebenen im Gehäuse. Es ist jedoch auch möglich, mehrere Leiterplatten, die kleinere Abmessungen als das Gehäuse aufweisen, in derselben Leiterplattenebene vorzusehen. Somit lassen sich in diesem Gehäuse viele unterschiedliche Steuerungen unterbringen, und mehrere unterschiedliche Stecksysteme sind nutzbar.

Gemäß einem Ausführungsbeispiel können die Aufnahmemittel in einer Ebene zur Aufnahme der Bauteile angeordnet sein und im Bereich einer Grundfläche eines jeweiligen Gehäuseteils vorgesehen sein. Damit kann durch die Aufnahmemittel die Ausrichtung und Lage der Bauteile definiert werden. Die Bauteile können als Leiterplatte vorgesehen sein. Die Ebene kann ferner zumindest annähernd parallel zu der Grundfläche ausgerichtet sein, so dass ein Bauteil jeweils angrenzend an die Grundfläche des jeweiligen Gehäuseteils angeordnet werden kann. Dies erleichtert eine Kontaktierung der Bauteile, insbesondere die Kontaktierung von außerhalb des Gehäuses.

Auf den Aufnahmemitteln kann eine Leiterplatte abgelegt und befestigt werden. Die Aufnahmemittel können aus Absätzen oder Vorsprüngen gebildet sein, welche gegenüber einer Grundfläche hervorstehen. Dabei kann die Grundfläche zumindest annähernd die Abmessungen einer Leiterplatte aufweisen. Die Aufnahmemittel können Befestigungsmittel, z.B. in Form von Rastmitteln, Bolzen, insbesondere Stehbolzen, Domen, umfassen oder mit diesen kombiniert vorliegen, so dass eine Leiterplatte durch Druck auf die Aufnahmemittel verrastbar ist, und z.B. durch seitliches Herausziehen wieder von einem Gehäuseteil gelöst werden kann. Die Aufnahmemittel können auf der Seite, auf welcher eine Leiterplatte zur Anlage kommen kann, im Wesentlichen eben ausgebildet sein. Bauteile mit viel Verlustleistung können vorteilhafterweise im Bereich der Befestigungsmittel angeordnet werden, da über die Befestigungsmittel auch eine Wärmeleitbrücke zu einer Gehäusewandung hergestellt werden kann. Die Aufnahmemittel können auch derart angeordnet sein, dass sie bei durch Druckgussverfahren hergestellten Gehäusen an der Stelle angeordnet sind, an welcher Auswerfer eines Druckgusswerkzeugs an dem Gehäuse angreifen. Die Abwärme kann dann über die Befestigungsmittel und eine Gehäusewandung und/oder Kühlrippen an die Umgebung abgegeben werden.

Durch die Aufnahmemittel kann sichergestellt werden, dass in jedem Gehäuseteil unabhängig von der Größe des Gehäuses die gleichen Einbaubedingungen für Bauteile bestehen, was die Montage erleichtert. Es können z.B. vier Aufnahmemittel vorgesehen sein, an welchen jeweils eine Befestigung einer Leiterplatte in einem Gehäuseteil erfolgen kann. Es können aber auch fünf, sechs oder noch mehr Aufnahmemittel vorgesehen sein. Die Aufnahmemittel können alle in derselben Ebene angeordnet sein bzw. dieselbe Ebene definieren, insbesondere jeweils über eine obere Stirnfläche, auf welcher eine Leiterplatte zur Anlage kommen kann. Dadurch kann eine sichere und robuste Auflage für die Leiterplatten bereitgestellt werden, und die Leiterplatten können je nach Anforderungen auf mehr oder weniger aufwendige Art und Weise mit dem Gehäuse verbunden werden.

Gemäß einem Ausführungsbeispiel ist die Aussparung für einen (Zentral-)Stecker des in dem ersten Gehäuseteil vorzusehenden Bauteils in dem zweiten Gehäuseteil vorgesehen. Ebenso kann die Aussparung für einen (Zentral-)Stecker des in dem zweiten Gehäuseteil vorzusehenden Bauteils in dem ersten Gehäuseteil vorgesehen sein. Durch diesen Aufbau des Gehäuses kann sichergestellt werden, dass eine besonders geringe Bauhöhe eingehalten werden kann und die Bauteile auf einfache Weise in den Gehäuseteilen montiert werden können. Auch kann sichergestellt werden, dass auch in einem Gehäuse unterschiedliche Stecksysteme zum Einsatz kommen können, also speziell bei Leiterplatten unterschiedliche Stecker mit voneinander abweichenden Abmessungen untergebracht werden können, ohne bedeutenden Änderungen an dem Gehäuse vornehmen zu müssen. Denn dadurch, dass die Aussparungen für die Steckerdurchführungen nur in einem von zwei aneinandergrenzenden Gehäuseteilen vorgesehen sind, ist es z.B. möglich, ein Gehäuseteil mit einer anderen bzw. abweichenden Aussparung auszuführen, ohne dass auch ein benachbart zu diesem Gehäuseteil anzuordnendes Gehäuseteil abgewandelt werden muss. So lassen sich bei dem Gehäuse einzelne Gehäuseteile spezifisch auslegen, ohne das gesamte Gehäuse abwandeln zu müssen.

Gemäß einem Ausführungsbeispiel können die Gehäuseteile derart aufgebaut sein, dass die Bauteile darin zueinander um 180 Grad gedreht sind. Speziell bei Leiterplatten können die Aussparungen für die Stecker der Leiterplatten bei benachbarten Leiterplatten bzw. Gehäuseteilen jeweils gegenüberliegend angeordnet sein, so dass die Leiterplatten zum einen in Bezug auf ihre Längskante um 180 Grad gedreht sind und mit ihren Oberseiten zueinander weisen, und zum anderen um eine senkrecht zu einer Ebene, in welcher sich eine Leiterplatte erstreckt, ausgerichteten Achse um 180 Grad gedreht sind und mit ihren Steckern in entgegengesetzte Richtungen weisen.

Gemäß einem Ausführungsbeispiel können die Gehäuseteile eine an die aufzunehmenden Bauteile angepasste Geometrie aufweisen, so dass bei im Wesentlichen rechteckig ausgebildeten Bauteilen im zusammengebauten Zustand ein im Wesentlichen quaderförmiges Gehäuse mit zwei Längsseiten und zwei Stirnseiten und einer spezifischen Höhe gebildet ist. Als Stirnseiten sind dabei jene Seiten zu verstehen, an welchen Stecker aus dem Gehäuse heraus geführt werden, also die Seiten, über welche die elektrische Kontaktierung sichergestellt werden kann. Bei einem solchen Gehäuse ist es dann vorteilhaft, wenn die Aussparung in dem ersten Gehäuseteil und die Aussparung in dem zweiten Gehäuseteil gegenüberliegenden Stirnseiten angeordnet sind. Mit anderen Worten kann die Aussparung in dem ersten Gehäuseteil an einer ersten Stirnseite des ersten Gehäuseteils angeordnet sein und die Aussparung in dem zweiten Gehäuseteil an einer zweiten Stirnseite des zweiten Gehäuseteils angeordnet sein, wobei in einem zusammengebauten Zustand des Gehäuses eine erste Stirnseite bzw. Steckerseite des ersten Gehäuseteils gegenüberliegend zu einer zweiten Stirnseite bzw. Steckerseite des zweiten Gehäuseteils ausgerichtet ist.

Durch diese Anordnung der Bauteil bzw. Leiterplatten und die damit einhergehenden wechselseitigen Steckerdurchführungen an gegenüberliegenden Stirnseiten kann das Gehäuse auch bei größeren Steckern verhältnismäßig flach ausgeführt sein. Eine Leiterplatte kann also an einer in Bezug auf eine benachbart angeordnete Leiterplatte gegenüberliegenden Seite des Gehäuses über die gebildete Durchführung elektrisch kontaktiert werden. Ein Vorteil besteht z.B. auch darin, dass bei dem platzsparenden Gehäuse die Stecker auch einfache Weise entfernt oder angesteckt werden können, denn zwischen einzelnen Steckern ist ausreichend Platz, da Stecker benachbarter Leiterplatten jeweils auf der gegenüberliegenden Stirnseite vorgesehen sind. Eine wechselseitige Kontaktierung der im Gehäuse vorgesehenen Bauteile bzw. Leiterplatten ermöglicht ein kompaktes Gehäuse und eine gute Zugänglichkeit der Bauteil, insbesondere zwecks Montage oder Demontage in den Gehäuseteilen, auch wenn die Stecker bereits vorgesehen sind.

Es sei erwähnt, dass eine erste Stirnseite des ersten Gehäuseteils einer zweiten Stirnseite des zweiten Gehäuseteils entsprechen kann, nämlich für den Fall, dass das Gehäuse aus einem zwei Gehäuseteilen zusammengesetzt ist, welche zueinander identisch bzw. deckungsgleich sind.

Für den Fall, dass die Leiterplatten nur von einer (Stirn-)Seite des Gehäuses kontaktiert werden sollen, z.B. bei besonderen Einbausituationen im Umfeld des Gehäuses, können auch auf der einen Stirnseite des Gehäuses Blindstecker vorgesehen werden und das Gehäuse entsprechend höher ausgeführt werden, um bei einer bestimmten Anzahl an Leiterplatten eine Kontaktierung nur an einer der beiden Stirnseiten des Gehäuses zu ermöglichen. Die Stecker benachbarter Leiterplatten sind dann nicht wechselseitig an den gegenüberliegenden Stirnseiten vorgesehen, sondern an der gleichen Stirnseite des Gehäuses.

Das erste und zweite Gehäuseteil können im Wesentlichen kongruent sein und in einem zusammengebauten Zustand asymmetrisch zueinander angeordnet sein, wobei die Kuppelbereiche als umlaufende stegartige Schnittstellen ausgebildet sein können. Asymmetrisch bedeutet in diesem Zusammenhang, dass zumindest im Bereich der Schnittstelle identisch aufgebaute Gehäuseteile um 180 Grad verdreht zueinander montiert werden, insbesondere wenn sie eine an einer Längsseite des Gehäuses schräg verlaufende Schnittstelle aufweisen. Die erste Stirnseite des einen Gehäuseteils bildet dann mit der zweiten Stirnseite des anderen Gehäuseteils eine stirnseitige Seitenfläche des Gehäuses.

Das erste und zweite Gehäuseteil können eine identische Geometrie und identische Abmessungen aufweisen. Durch zwei identische oder zumindest im Wesentlichen kongruente Gehäuseteile kann ein Gehäuse mit gleichen Einbaubedingungen für die darin anzuordnenden Leiterplatten bereitgestellt werden. Dies erleichtert die Montage der Leiterplatten und reduziert die Anzahl der unterschiedlichen Teile und Montagewerkzeuge. Dadurch kann auch ein besonders kostengünstig herstellbares Gehäuse bereitgestellt werden.

Gemäß einem Ausführungsbeispiel können die Gehäuseteile jeweils zwei gegenüberliegende Stirnseiten mit unterschiedlich großen Stirnflächen aufweisen. Eine Aussparung kann jeweils an der Stirnseite mit der jeweils größeren Stirnfläche vorgesehen sein. Dadurch kann eine gute Zugänglichkeit zu den Bauteilen und den Steckern sichergestellt werden, und die Montage ist erleichtert. Die Bauteile können auf einfache Weise von der Seite mit der kleineren Stirnfläche eingebracht werden. Beispielsweise können sie seitlich in das Gehäuse geschoben werden. Gleichzeitig kann eine Durchführung für einen Stecker auf der größeren Stirnseite bereitgestellt werden. In dieser Durchführung kann ein Bauteil über mittels seines entsprechenden Steckers dann auch ausgerichtet und gehalten werden bevor es in dem Gehäuseteil reversibel oder irreversibel montiert wird. Als Bauteil kann jeweils eine Leiterplatte vorgesehen sein, und in den Gehäuseteilen kann jeweils mindestens eine Leiterplattenebene vorgesehen sein zur Anordnung mindestens eines Bauteils in Form einer Leiterplatte. Die Leiterplattenebene kann durch die Aufnahmemittel festgelegt sein, und die Aufnahmemittel können durch Vorsprünge oder Absätze oder Sockel oder Leisten oder Führungen gebildet sein, an welchen eine jeweilige Leiterplatte fixiert werden kann, z.B. durch eine Schraubverbindung.

Gemäß einem Ausführungsbeispiel kann der Kuppelbereich eines jeweiligen Gehäuseteils umlaufend ausgebildet sein und jeweils an Längsseiten entweder parallel zur Grundfläche G oder zumindest über eine Teilstrecke in einem Winkel gegenüber der Grundfläche verlaufen. Der Winkel kann z.B. im Bereich von 10 bis 60 Grad liegen, bevorzugt im Bereich von 15 bis 35 Grad.

Mit anderen Worten kann der Kuppelbereich also in einer bestimmten Ausrichtung gegenüber der Grundfläche verlaufen und auch eine spezifische Geometrie aufweisen. Die Gehäuseteile können eine im Verhältnis zu ihrer Ebene bzw. Leiterplattenebene schräg, d.h. in einem Winkel gegenüber einer x-y-Ebene, entlang der Längsseite verlaufende Schnittstelle (Kuppelbereich) aufweisen. Dadurch kann eine Leiterplatte in dem jeweiligen Gehäuseteil leicht zugänglich montiert bzw. demontiert werden, insbesondere von der Seite, zu welcher die Schnittstelle abfällt und das Gehäuseteil demnach die kleinste Höhe aufweist. Die Gehäusewandungen können daher auch sehr nah an der Leiterplatte vorgesehen sein. D.h., das Gehäuse selbst muss kaum breiter als eine Leiterplatte ausgeführt sein, und trotzdem ist eine einfache Montage von einer Vielzahl von Leiterplatten in dem Gehäuse möglich. Auch kann die schräg verlaufende Schnittstelle bzw. der Schrägschnitt das Zusammenfügen der beiden Gehäuseteile erleichtern, da die Gehäuseteile aufgrund der schräg angeordneten Kupplungsbereiche intuitiv in eine korrekte Lage zueinander verschoben werden können, so dass sie exakt aufeinander anliegen.

Der Kuppelbereich muss jedoch nichtschräg verlaufen. Je nach Herstellungsverfahren kann es vorteilhaft sein, wenn die Seitenkanten eines Gehäuseteils jeweils in derselben Höhe gegenüber einer Leiterplattenebene hervorstehen, da dann überall dieselben Entformungsschrägen bzw. -Winkel vorgesehen sein können. Bei einem im Druckgussverfahren hergestellten Gehäuseteil kann es daher aus fertigungstechnischen Gründen vorteilhaft sein, wenn die Kuppelbereiche im Wesentlichen parallel zu einer Leiterplattenebene verlaufen.

Der Kuppelbereich des ersten und zweiten Gehäuseteils kann also entlang von zwei gegenüberliegenden Längsseiten des jeweiligen Gehäuseteils zumindest über eine Teilstrecke in einem Winkel gegenüber den Gehäusegrundflächen verlaufen, so dass die Gehäuseteile entlang des Kuppelbereichs eine sich zumindest über eine Teilstrecke kontinuierlich ändernde Höhe aufweisen.

Die Leiterplattenebene kann in einer Höhe vorgesehen sein, welche größer ist als die geringste Höhe des jeweiligen Gehäuseteils. Dadurch ist eine jeweilige Leiterplatte auf einfache Weise zugänglich, insbesondere weil die Leiterplatte im offenen Zustand nicht vollständig von einem Gehäuserand umgrenzt wird und somit z.B. einfach zu einer Seite herausgezogen werden kann. Besonders vorteilhaft ist es, wenn eine jeweilige Leiterplatte dann auch auf derjenigen Seite mit dem Stecker kontaktiert wird, auf welcher sie aus dem einen Gehäuseteil herausnehmbar ist. D.h., das jeweilige Gehäuseteil weist an derjenigen Seite die Aussparung auf, welche die größte Höhe aufweist.

Das erste und zweite Gehäuseteil können im Bereich der Aufnahmemittel Mittel zur Befestigung von Leiterplatten aufweisen, welche jeweils in jenem Bereich der Gehäuseteile angeordnet sind, der die geringste Höhe des Gehäuseteils aufweist, so dass Leiterplatten auf einfache Weise in den Gehäuseteilen montierbar oder demontierbar sind. Die Mittel zur Befestigung von Leiterplatten können z.B. als Klemmleisten oder als Rastnasen ausgebildet sein.

An den Längsseiten und/oder Stirnseiten der Gehäuseteile könne Kühlrippen, insbesondere senkrecht zu den äußere Längsflächen und/oder Stirnflächen verlaufend vorgesehen sein. Auch im Bereich der winkelig verlaufenden Schnittstellen können Kühlrippen außen an den Längsflächen der Gehäuseteile vorgesehen sein. Die Kühlrippen erstrecken sich z.B. senkrecht zu einer Gehäusegrundfläche, und stellen eine Wärmeleitbrücke zwischen einer Grundfläche oder annähernd parallel zu dieser verlaufenden internen Wandungen in dem Gehäuse her. Kühlrippen sind jedoch kein notweniges konstruktives Merkmal, um eine ausreichende Wärmeabfuhr sicherzustellen. Es hat sich gezeigt, dass die Wärmestrahlung bei den erfindungsgemäßen Gehäusen auch ohne Kühlrippen ausreichend hoch ist, insbesondere wenn das Gehäuse aus Aluminiumdruckguss hergestellt ist. Nichtsdestotrotz kann die Oberfläche Rille, Wellen oder dergleichen Profile aufweisen um die Oberfläche zu erhöhen und die Wärmeabfuhr zu verbessern.

Die Gehäuseteile können jeweils eine Dichtung aufweisen, welche in dem Kuppelbereich vorgesehen ist, und welche in einem zusammengebauten Zustand eine Abdichtung an den Durchführungen sicherstellen. In einer Ausführungsform ist die Dichtung umlaufend. Die Gehäuseteile können in dem Kuppelbereich eine Nut zur Aufnahme einer Dichtung aufweisen. Nut und Dichtung können umlaufend ausgebildet sein. Damit kann die Abdichtung des Gehäuses in einem zusammengebauten Zustand in dem Kuppelbereich durch zwei aufeinanderliegende Dichtungen sichergestellt werden, also durch Dichtungen, die beidseitig an beiden Gehäuseteilen vorgesehen sind. Im Bereich der die Leiterplatten kontaktierenden Stecker liegt dann die Dichtung eines jeweiligen Gehäuseteils unmittelbar auf dem entsprechenden Stecker an. Die Dichtung kann auch auf ein jeweiliges Gehäuseteil aufgespritzt werden.

Speziell für Außenbereich-Anwendungen, welche eine Beständigkeit gegenüber Schmutz, Staub und Wasser gemäß einer bestimmten Schutzart, z.B. IP55, IP66, oder gar IP67 oder IP68, erfordern, ist nicht nur ein robustes, sondern auch ein hermetisch dichtes Gehäuse erforderlich. Durch den symmetrischen Aufbau der Gehäuseteile kann eine Abdichtung auf einfache Weise erfolgen, z.B. mittels eines Formgummis, und die Abdichtung kann in Verbindung mit einer geeigneten Verbindungsart der Gehäuseteile untereinander auch eine Dichtheit gemäß einem hohen Standard sicherstellen, z.B. gemäß der Schutzart IP65, IP66, oder auch IP67 oder IP68.

Als Formgummi ist dabei eine Dichtung zu verstehen, welche an die Geometrie des Gehäuses angepasst ist, und welche dem Verlauf des Kuppelbereichs folgt. Die Dichtung weist somit bereits selbst die Geometrie des Kuppelbereichs der Gehäuseteile auf, vorzugsweise in allen drei Dimensionen, so dass bei einem Einlegen der Dichtung, z.B. in eine Nut eines jeweiligen Gehäuseteils, keine Verspannungen oder Querschnittsänderungen aufgrund von Dehnung oder Stauchung der Dichtung auftreten. Die Dichtung kann unterschiedliche Dicken aufweisen, z.B. dicker ausgeführt sein in einem Bereich, in welchem durch aneinandergrenzende Gehäuseteile eine Steckerdurchführung gebildet ist.

Als geeignete Verbindungsart kann ein Verspannen einzelner Gehäuseteile untereinander erfolgen, z.B. mittels Schraubverbindungen. Es kann aber auch ein Verspannen aller Gehäuseteile in serieller Art und Weise mit entlang aller Gehäuseteile geführten Verbindungsmitteln erfolgen.

Die Gehäuseteile können aus Aluminium bestehen. Die Gehäuseteile können im Kuppelbereich an mindestens zwei Stellen Verbindungsbereiche aufweisen, an welchen Verbindungsmittel zum Verbinden der Gehäuseteile vorgesehen sein können. Die Verbindungsbereiche können in Form von Durchgangsführungen ausgebildet sind, welche sich entlang der Längsflächen der Gehäuseteile erstrecken und in einem zusammengebauten Zustand an denselben Stellen der Gehäuseteile angeordnet sind, so dass die Verbindungsmittel jeweils durch die miteinander fluchtenden Durchgangsführungen aller Gehäuseteile zum Verspannen der Gehäuseteile geführt werden können.

Ferner können Mittel zum Wärmeleiten zwischen dem innenliegenden Boden bzw. einer Grundfläche eines Gehäuseteils und einer darin einsetzbaren Leiterplatte vorgesehen sein. Die Mittel zum Wärmeleiten können durch eine Wärmeleitfolie und/oder durch ein innenliegendes Kühlblech und/oder Aluminium-Strangpressprofil gebildet sein. Ein Aluminium-Strangpressprofil kann dabei von oben auf eine Leiterplatte gesetzt werden, und die Bauelemente auf der Leiterplatte können direkt kontaktiert werden, üblicherweise unter Zwischenschaltung eines Wärmeleitmaterials in Form eines Wärmeleit-Pads oder einer Wärmeleit-Matte aus einem Keramik enthaltenden elastischen Material.

Gemäß einem Ausführungsbeispiel sind das erste und zweite Gehäuseteil schalenartig ausgebildet, und das Gehäuse weist ein drittes Gehäuseteil in Form eines z.B. rahmenartigen oder kastenartigen Zwischengehäuseteils mit zwei gegenüberliegenden Kuppelbereichen auf, welches in einem zusammengebauten Zustand des Gehäuses zwischen dem ersten und zweiten Gehäuseteil angeordnet ist. Das dritte Gehäuseteil kann im jeweiligen Kuppelbereich eine Aussparung für einen elektrischen Stecker aufweisen, wobei die Aussparungen an gegenüberliegenden Stirnseiten des Zwischengehäuseteils angeordnet sind, und wobei das Zwischengehäuseteil symmetrisch in Bezug auf zwei in dem Zwischengehäuseteil vorgesehenen Ebenen zur Aufnahme von Bauteilen ausgeführt ist, so dass der eine Kuppelbereich des dritten Gehäuseteils mit dem Kuppelbereich des ersten Gehäuseteils korrespondiert und der andere Kuppelbereich des dritten Gehäuseteils mit dem Kuppelbereich des zweiten Gehäuseteils korrespondiert.

Die einfachste Art, ein erfindungsgemäßes Gehäuse für eine größere Anzahl an Leiterplatten zu erweitern, ist die Erweiterung in die Höhenrichtung durch Hinzufügen weiterer Zwischengehäuseteile.

Das dritte Gehäuseteil bzw. Zwischengehäuseteil kann eine Zwischenwandung aufweisen, welche im Bereich eines mittleren Betrags der Höhe des dritten Gehäuseteils vorgesehen ist, und an welcher beidseitig jeweils eine Ebene für Bauteile bzw. eine Leiterplatte vorgesehen ist, und die Ebene ist durch Aufnahmemittel festgelegt. Die Zwischenwandung kann dadurch gebildet sein, dass das Zwischengehäuseteil durch zwei Gehäuseteile gebildet ist, welche mit ihren Grundflächen aufeinander anliegen und miteinander verbunden sind, z.B. verklebt oder verschraubt. In dem Zwischengehäuseteil können somit wahlweise eine oder zwei oder auch mehr als zwei Leiterplatten angeordnet sein. Mehrere Bauteile in einem Zwischengehäuseteil können intern verbunden werden, was z.B. gut möglich ist, wenn die Bauteile beidseitig einer Zwischenwandung angeordnet sind. Sollen mehrere Zwischengehäuseteile miteinander kombiniert werden, um das Gehäuse kaskadenartig zu erweitern, so können auch in einem Zwischengehäuseteil, welches beidseitig an ein weiteres Zwischengehäuseteil grenzt, zwei Leiterplatten angeordnet sein. Dieser Gehäuseaufbau führt somit gemäß einem der Ausführungsbeispiele bei einem Zwischengehäuseteil zu einem Gehäuse für drei oder vier Leiterplatten, bei zwei Zwischengehäuseteilen zu einem Gehäuse für vier bis sechs Leiterplatten, und bei drei Zwischengehäuseteilen zu einem Gehäuse für fünf bis acht Leiterplatten, und so weiter, insbesondere unter der Annahme, dass sowohl im ersten als auch im zweiten Gehäuseteil eine Leiterplatte vorgesehen ist. Damit kann durch ein erfindungsgemäßes Gehäuse auch bei speziellen Einbausituationen durch Erweiterung des Gehäuses über die Zwischengehäuseteile eine Kontaktierung aller Leiterplatten an nur einer der Stirnseiten erfolgen. Die in diesem Fall dann nicht durch Stecker belegten Aussparungen bzw. Durchführungen können mit Blinddeckeln verschlossen werden, z.B. falls ein hermetisch dichtes Gehäuse bei einer jeweiligen Anwendung gefordert ist.

Sollen in dem Gehäuse Bauteile, insbesondere Leiterplatten, mit unterschiedlichen Steckern vorgesehen werden, so kann mit einem spezifisch auf einen bestimmten Steckertyp ausgelegten Zwischengehäuse sichergestellt werden, dass auch diese abweichenden Stecker durch das Gehäuse geführt werden können, insbesondere auch bei hermetischer Abdichtung des Gehäuses, ohne dass Änderungen an den weiteren Gehäuseteilen oder zusätzlichen Zwischengehäuseteilen erforderlich wären. Insbesondere können Aussparungen in einem solchen Zwischengehäuse spezifisch ausgelegt und geometrisch ausgebildet sein. Denn da die Aussparungen für die Steckerdurchführungen im zusammengebauten Zustand des Gehäuses jeweils nur in einem von zwei aneinandergrenzenden Gehäuseteilen vorgesehen sind, und mit dem anderen angrenzenden Gehäuseteil lediglich eine Kante bereitgestellt wird, welche im zusammengebauten Zustand mit der Aussparung des einen Gehäuseteils eine Durchführung bildet, kann die Durchführung auch gebildet werden, wenn die Geometrie der Aussparung verändert wurde. Mit anderen Worten kann das Gehäuse z.B. durch ein erstes und zweites Gehäuseteil mit Aussparungen für einen ersten Steckertyp sowie durch ein oder mehrere Zwischengehäuseteile mit Aussparungen für einen zweiten Steckertyp mit vom ersten Steckertyp abweichender Geometrie gebildet sein.

Ferner wird ein Zwischengehäuse bereitgestellt, welches mit den ersten und zweiten Gehäuseteilen zusammen das Gehäuse bilden kann, und welches dazu vorgesehen ist, zwischen dem ersten und zweiten Gehäuseteil angeordnet zu werden, wobei das Zwischengehäuseteil zwei gegenüberliegende Kuppelbereiche aufweist und im jeweiligen Kuppelbereich eine Aussparung für einen elektrischen Stecker aufweist, und wobei die Aussparungen an gegenüberliegenden Stirnseiten des Zwischengehäuseteils angeordnet sind. Durch ein solches Zwischengehäuse kann ein Gehäuse bereitgestellt werden, welches beliebig erweiterbar ist, insbesondere in eine Höhen-Richtung, durch ein oder mehrere Zwischengehäuseteile, die mit dem ersten und zweiten Gehäuseteil verbunden werden können, insbesondere zwischen dem ersten und zweiten Gehäuseteil verspannt werden können.

Das Zwischengehäuseteil kann z.B. rahmenartig ausgebildet sein, wobei der Begriff "rahmenartig" auf eine Seitenwand hinweist, welche das Zwischengehäuseteil umgrenzt. Es kann eine innenliegende Wandung aufweisen, welche das Zwischengehäuseteil in zwei Kompartimente unterteilt. Eine solche Wandung kann als Schott ausgebildet sein, welches sich zumindest annähernd parallel zu in dem Zwischengehäuseteil vorgesehene Ebenen zur Aufnahme von Bauteilen erstreckt. Das Schott kann mit einer spezifisch im Hinblick auf Wärmeleitung definierten Wandstärke ausgeführt sein. Bei einem eher kastenförmigen Zwischengehäuseteil kann das Schott eher als eine Art Zwischenboden beschrieben werden. Die Wandstärke kann der Wandstärke der Längs- oder Stirnseiten des Zwischengehäuseteils entsprechen, sie kann aber auch davon abweichen, z.B. doppelt so stark sein. Das Zwischengehäuseteil bzw. dritte Gehäuseteil kann in den beiden Kuppelbereichen jeweils eine umlaufende Dichtung aufweisen, welche z.B. in eine Nut eingelegt ist. Die Dichtung kann als Formgummi ausgeführt sein, welcher entsprechend der Geometrie des Gehäusteils geformt ist.

Gemäß einem Ausführungsbeispiel ist das Zwischengehäuseteil aus zwei Gehäuseteilen ausgeführt, die mit ihrer jeweiligen Grundfläche aneinander anliegen. D.h., das Zwischengehäuseteil kann dadurch hergestellt werden, dass zwei Stück eines ersten oder zweiten Gehäuseteils hergestellt und miteinander gekoppelt werden, was in Abhängigkeit des Gehäusematerials durch Kleben, Schweißen, Verschrauben, oder auch andere Verbindungsmittel erfolgen kann. Somit kann das gesamte Gehäuse unabhängig von der Größe des Gehäuses durch eine einzige Grundform hergestellt werden, welche dem ersten bzw. zweiten Gehäuseteil entspricht. Dies kann schon allein aufgrund der höheren Stückzahlen dieses einen Gehäuseteils die Herstellungskosten reduzieren, aber auch die Anzahl der erforderlichen Komponenten zum Zusammenbauen des Gehäuses. Das Zwischengehäuseteil kann aber auch als eigenständige Konstruktion ausgeführt sein und einstückig ausgebildet sein. Dies ist z.B. dann vorteilhaft, wenn eine spezifische Anwendung spezielle Wärmetransport-Eigenschaften des Zwischengehäuseteils erfordert. Grundsätzlich kann auch bei einem aus zwei ersten oder zweiten miteinander gekoppelten Gehäuseteilen gebildeten Zwischengehäuseteil eine Wärmeableitung von den im Gehäuse angeordneten Bauteilen an die Umgebung erfolgen. Das Zwischengehäuseteil kann hierfür im Verhältnis zu einem ersten oder zweiten Gehäuseteil längere Kühlrippen an der Mantelfläche aufweisen, und die Wärme kann von einem Bauteil bzw. einer Leiterplatte auf die Grundfläche, an welcher eine Leiterplatte mit einer ersten Seite anliegt, geführt werden, und von dort zu den Kühlrippen, wobei zwischen Leiterplatte und Gehäuse eine Wärmeleitpaste oder -folie und/oder eine zusätzliche eine zweite Seite der Leiterplatte kontaktierende Platte vorgesehen sein kann. Zudem kann es in Abhängigkeit des Materials des Gehäuses der Fall sein, dass bei dem aus zwei Gehäuseteilen gebildeten Zwischengehäuseteil die doppelte Stärke der durch die Grundflächen der Gehäuseteile gebildeten Zwischenwandung zu einer besseren Leitfähigkeit führt als die einzelne Wandung bei einem einzelnen ersten oder zweiten Gehäuseteil. Ist das Zwischengehäuseteil aber als eigenständige Konstruktion ausgeführt und einstückig ausgebildet, so kann die Zwischenwandung in ihrer Stärke frei gewählt werden, z.B. im Hinblick auf optimierte Wärmeabführung.

Das Zwischengehäuseteil kann als Parallelogrammrahmen mit Längsflächen und Stirnflächen ausgebildet sein, bei welchem die Längsflächen jeweils die Geometrie eines Parallelogramms aufweisen, dessen Seiten die Längsseiten und die in Höhenrichtung ausgerichtete Seite bilden, und bei welchem der kleinere Winkel zwischen benachbarten Seiten der Längsflächen im Bereich von 10 bis 60 Grad liegt, bevorzugt im Bereich von 15 bis 35 Grad.

Zur Befestigung des Gehäuses, z.B. in einer Außenumgebung an einem Kran oder Baufahrzeug, können Befestigungsflansche am Boden-Grundelement des Gehäuses vorgesehen sein, und/oder es kann eine Art Befestigungsblech an einer der Kühlrippen oder den Längs- bzw. Stirnseiten des Gehäuses vorgesehen sein.

Ferner wird ein Verfahren zur Montage eines erfindungsgemäßen Gehäuses vorgeschlagen, wobei das Verfahren die Schritte umfasst:
- Bereitstellen eines ersten Gehäuseteils und Befestigen eines ersten Bauteils in dem ersten Gehäuseteil durch Fixieren des Bauteils in einer Ebene des ersten Gehäuseteils, wobei an dem ersten Bauteil ein Stecker vorgesehen ist, welcher an einer Stirnseite des ersten Gehäuseteils aus dem Gehäuseteil hervorsteht;
- Vorsehen einer Dichtung in einem Kuppelbereich des ersten Gehäuseteils;
- Bereitstellen eines zweiten Gehäuseteils;
- optional Befestigen eines zweiten Bauteils in dem zweiten Gehäuseteil durch Fixieren des Bauteils in einer Ebene des zweiten Gehäuseteils, wobei an dem zweiten Bauteil ein Stecker vorgesehen ist, welcher an einer Stirnseite des zweiten Gehäuseteils aus dem Gehäuseteil hervorsteht;
- Vorsehen einer Dichtung in einem Kuppelbereich des zweiten Gehäuseteils;
- in Verbindung Bringen des ersten Gehäuseteils mit dem zweiten Gehäuseteil derart, dass in einem zusammengebauten Zustand die Stirnseite mit Stecker des ersten Gehäuseteils gegenüberliegend zu der Stirnseite mit Stecker des zweiten Gehäuseteil angeordnet ist;
- Abdichten des Gehäuses an den Kuppelbereichen durch Verspannen der Gehäuseteile gegeneinander.

Gemäß einer Ausführungsform kann das Verfahren ferner die Schritte umfassen:
- Bereitstellen mindestens eines erfindungsgemäßen Zwischengehäuseteils,
- Befestigen mindestens eines Bauteils in einer Ebene in dem Zwischengehäuseteil, wobei das Bauteil mit mindestens einem Stecker gekuppelt ist, welcher an einer Seite des Zwischengehäuseteils aus dem Gehäuse ragt;
- vor dem in Verbindung Bringen des ersten Gehäuseteils mit dem zweiten Gehäuseteil: in Verbindung Bringen des Zwischengehäuseteils mit dem ersten Gehäuseteil;
- in Verbindung Bringen des zweiten Gehäuseteils mit dem Zwischengehäuseteil derart, dass in einem zusammengebauten Zustand der Stecker für das im ersten oder zweiten Gehäuseteil vorgesehene Bauteil gegenüberliegend zu dem Stecker für ein benachbart in dem Zwischengehäuseteil vorgesehenen Bauteil angeordnet ist.

Die Verfahrensschritte bei der Montage eines erfindungsgemäßen Gehäuses können in einer von der aufgeführten Reihenfolge der Verfahrensschritte abweichenden Reihenfolge ausgeführt werden. Bevorzugt wird eine Dichtung in dem ersten und/oder zweiten Gehäuseteil vorgesehen, bevor ein Bauteil in dem jeweiligen Gehäuseteil befestigt wird.

Ferner wird ein Verfahren zur Herstellung der Komponenten eines erfindungsgemäßen Gehäuses und zur Bereitstellung der Komponenten zwecks Montage des Gehäuses vorgeschlagen, wobei das Verfahren die Schritte umfasst:
Bereitstellen einer Gussform für ein Gehäuseteil;
   - Giessen eines ersten und zweiten Gehäuseteils mit der Gussform, wobei die Gehäuseteile jeweils einen Kuppelbereich aufweisen;
   - Bereitstellen eines Werkzeugs für eine Dichtung für die Gehäuseteile, wobei das Werkzeug dazu ausgebildet ist, der Dichtung eine an den Kuppelbereich des jeweiligen Gehäuseteils angepasste Form zu verleihen, d.h. der Geometrie des Kuppelbereichs des jeweiligen Gehäuseteils zu entsprechen;
   - Herstellen einer ersten und zweiten Dichtung mit dem Werkzeug;
   - Einlegen der ersten Dichtung in das erste Gehäuseteil, insbesondere in den Kuppelbereich des ersten Gehäuseteils, und Einlegen der zweiten Dichtung in das zweite Gehäuseteil, insbesondere in den Kuppelbereich des zweiten Gehäuseteils.

Das Verfahren zur Herstellung der Komponenten eines erfindungsgemäßen Gehäuses kann dahingehend weitergebildet sein, dass mindestens ein Zwischengehäuseteil hergestellt wird, insbesondere mittels der Gussform für das Gehäuseteil, wobei das Zwischengehäuseteil dazu vorgesehen ist, zwischen dem ersten und zweiten Gehäuseteil verbaut zu werden, und das Zwischengehäuseteil weist zwei Kuppelbereiche definierter Geometrie auf.

Das Verfahren zur Herstellung der Komponenten eines erfindungsgemäßen Gehäuses kann ferner dahingehend weitergebildet sein, dass das Zwischengehäuseteil aus zwei Gehäuseteilen, welche jeweils eine Grundfläche aufweisen, gebildet wird, indem die beiden Gehäuseteils an ihren Grundflächen miteinander verbunden werden, so dass die Grundflächen eine innenliegende Wandung des Zwischengehäuseteils bilden.

Die Gehäuseteile und Zwischengehäuseteile können z.B. durch ein Druckgussverfahren wie z.B. Spritzguss hergestellt werden. Als Material kann ein wärmeleitfähiges Metall, wie z.B. Aluminium, verwendet werden, insbesondere die Legierung 230 nach DIN EN1706:006/98 (chemische Bezeichnung EN AC -AlSi12(Fe), numerische Bezeichnung EN AC -44300). Es kann auch ein Kunststoffmaterial gewählt werden, welches gemäß einer Variante spezifische Zusätze im Hinblick auf gute Wärmeleitung aufweisen kann. Die Oberflächen der Gehäuseteile, insbesondere die äußeren Oberflächen, können unbehandelt oder behandelt sein. Eine behandelte Oberfläche kann im Hinblick auf verbesserte Wärmestrahlung oder Konvektion behandelt sein, z.B. sandgestrahlt sein. Es kann auch eine Lackierung vorgesehen sein, insbesondere im Hinblick auf verbesserte Wärmestrahlung oder Konvektion.

Somit ist jeweils ein Werkzeug für die Dichtungen, für die Gehäuseteile und für die Zwischengehäuseteile erforderlich, wobei die Gehäuseteile und die Zwischengehäuseteile auch mit ein und demselben Werkzeug hergestellt werden können, insbesondere in dem Fall, dass ein Zwischengehäuseteil durch zwei Gehäuseteile gebildet werden kann.

Es sei erwähnt, dass die oben beschriebenen Merkmale und Ausführungsformen miteinander kombinierbar sind und auch die einzelne Merkmale der im Folgenden beschriebenen Ausführungsbeispiele auf eines der anderen Ausführungsbeispiele übertragbar sind, wenn dies nicht explizit verneint wurde oder aus sich heraus offensichtlich ist.

Die Erfindung wird anhand der nachfolgenden Figuren noch näher erläutert unter Bezugnahme auf einzelne Ausführungsbeispiele.

Es zeigen
- Fig. 1a, b: eine schematische Ansicht auf eine der Längsseiten bzw. eine der Stirnseiten eines Gehäuses gemäß einem ersten Ausführungsbeispiel der vorliegenden Erfindung in einer Explosionsdarstellung, bei welchem ein Zwischengehäuseteil vorgesehen ist, und welches zur Aufnahme von mindestens vier Leiterplatten ausgebildet ist;
- Fig. 2a, b: eine schematische Ansicht auf eine der Längsseiten bzw. eine der Stirnseiten eines Gehäuses gemäß einem zweiten Ausführungsbeispiel der vorliegenden Erfindung in einer Explosionsdarstellung, bei welchem zwei Zwischengehäuseteile vorgesehen sind, und welches zur Aufnahme von mindestens sechs Leiterplatten ausgebildet ist;
- Fig. 3a, b: eine schematische Draufsicht auf ein erstes Gehäuseteil und auf ein Zwischengehäuseteil eines Gehäuses gemäß dem ersten Ausführungsbeispiel der vorliegenden Erfindung;
- Fig. 4a, b: eine schematische Ansicht auf ein Gehäuses gemäß einem dritten Ausführungsbeispiel der vorliegenden Erfindung in einem zusammengebauten Zustand, bei welchem ein Zwischengehäuseteil vorgesehen ist, und bei welchem mit Steckern kontaktierte Leiterplatten vorgesehen sind;
- Fig. 5a,b,c,d: technische Zeichnungen in verschiedenen Ansichten eines ersten bzw. zweiten Gehäuseteils für ein Gehäuse gemäß dem dritten Ausführungsbeispiel der Erfindung;
- Fig. 6a,b,c: technische Zeichnungen in verschiedenen Ansichten eines Zwischengehäuseteils für ein Gehäuse gemäß dem dritten Ausführungsbeispiel der Erfindung;
- Fig. 7a,b,c: technische Zeichnungen einer Dichtung für ein Gehäuse gemäß dem dritten Ausführungsbeispiel in verschiedenen Ansichten;
- Fig. 8a: eine perspektivische Ansicht eines Gehäuse gemäß einem vierten Ausführungsbeispiel;
- Fig. 8b: eine Schnittansicht als Strichzeichnung eines Gehäuse gemäß dem vierten Ausführungsbeispiel;
- Fig. 9a,b: eine perspektivische Ansicht sowie eine Schnittansicht eines Gehäuse gemäß dem fünften Ausführungsbeispiel;
- Fig. 10a,b: eine perspektivische Ansicht sowie eine Schnittansicht eines Gehäuse gemäß einem sechsten Ausführungsbeispiel;
- Fig. 11a,b: eine perspektivische Ansicht sowie eine Schnittansicht eines Gehäuse gemäß einem siebten Ausführungsbeispiel;
- Fig. 12a,b: eine perspektivische Ansicht sowie eine Schnittansicht eines Gehäuse gemäß einem achten Ausführungsbeispiel;
- Fig. 13a,b: eine perspektivische Ansicht sowie eine Schnittansicht eines Gehäuse gemäß einem neunten Ausführungsbeispiel;
- Fig. 14a,b: eine perspektivische Ansicht sowie eine Schnittansicht eines Gehäuse gemäß einem zehnten Ausführungsbeispiel;
- Fig. 15a,b, c: jeweils eine perspektivische Ansicht eines Gehäuse gemäß einem elften, zwölften und dreizehnten Ausführungsbeispiel; und
- Fig. 16a,b: eine perspektivische Ansicht sowie eine Schnittansicht eines Gehäuse gemäß einem elften Ausführungsbeispiel.

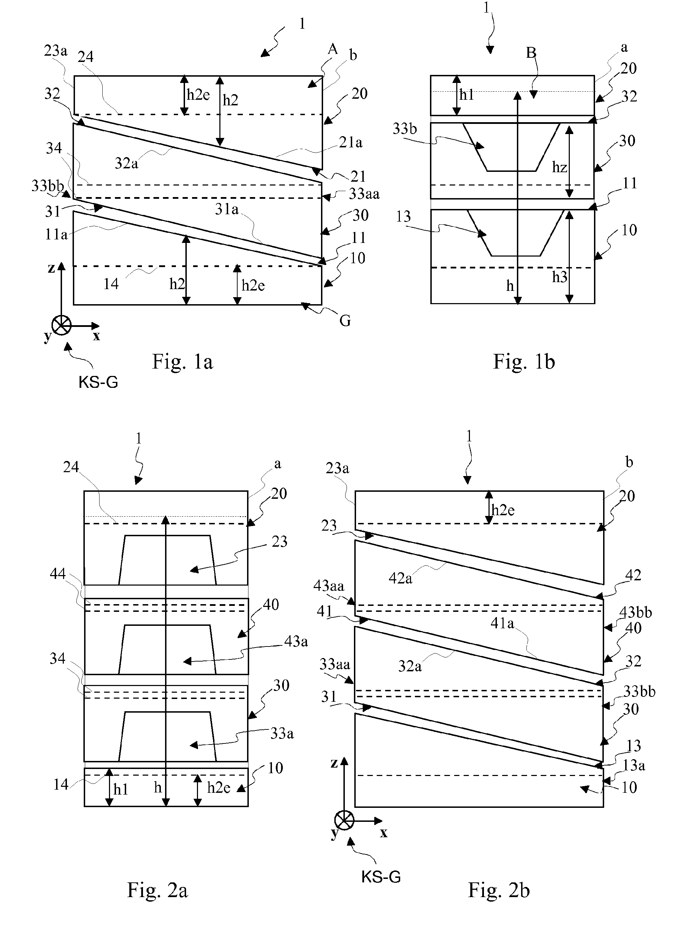

In den Figuren 1a, 1b, 2a, 2b sind zwei Ausführungsbeispiele eines erfindungsgemäßen Gehäuses 1 gezeigt, wobei jeweils ein erstes und zweites Gehäuseteil 10, 20 sowie ein oder zwei Zwischengehäuseteile 30, 40 gezeigt sind. Die Zwischengehäuseteile 30, 40 können zwischen dem ersten und zweiten Gehäuseteil 10, 20 eingesetzt werden, und das gesamte Gehäuse 1 kann dann durch Verbinden, insbesondere Verspannen, aller Gehäuseteile miteinander geschlossen werden. Der sandwichartige Aufbau des Gehäuses 1 ermöglicht eine kaskadenartige Erweiterung um eine beliebige Anzahl an Zwischengehäuseteilen 30, 40.

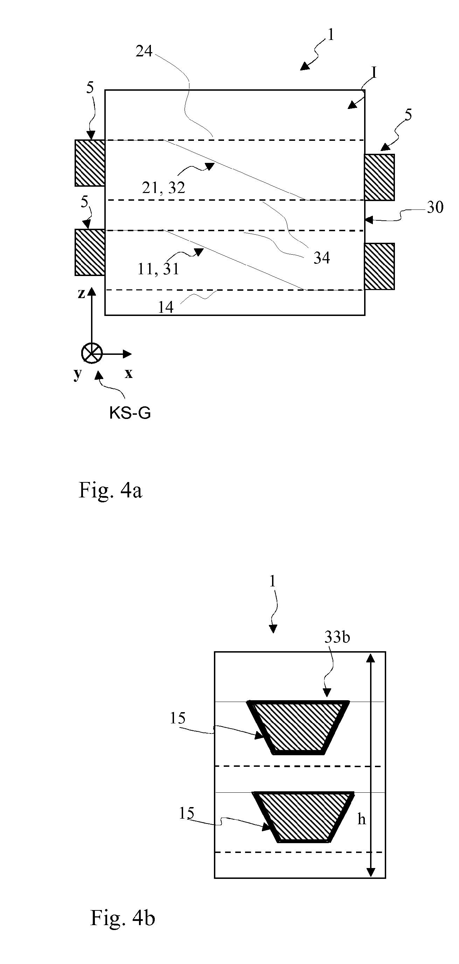

In der Fig. 1a ist eine Seitenansicht auf eine Stirnseite eines Gehäuses 1 mit einer Blickrichtung in x-Richtung gemäß einem ersten Ausführungsbeispiel gezeigt. Es ist gezeigt, auf welche Weise die Gehäuseteile 10, 20, 30 ausgestaltet sein können, damit elektronische Komponenten leicht darin montierbar sind und auch das Gehäuse 1 selbst leicht montiert werden kann. An dem ersten Gehäuseteil 10 erstreckt sich eine gegenüber einer x-Achse eines Gehäuse-Koordinatensystems KS-G winkelig verlaufende Teilstrecke 11a der Schnittstelle 11 derart, dass das Gehäuseteil 10 in x-Richtung hin eine abnehmende Höhe (gemessen in der z-Richtung des Gehäuse-Koordinatensystems KS-G) aufweist. Die Höhe ist dort am geringsten, wo die elektronischen Komponenten mit einem Stecker zu kontaktieren sind. Dies gilt gleichermaßen in entgegengesetzter Richtung für das zweite Gehäuseteil 20, wobei in Fig. 1b die geringste Höhe des ersten bzw. zweiten Gehäuseteils 10, 20 mit dem Bezugszeichen h1 angedeutet ist, und wobei die größte Höhe des ersten bzw. zweiten Gehäuseteils 10, 20 mit dem Bezugszeichen h3 angedeutet ist. Eine spezifische Höhe h2, die betragsmäßig zwischen h1 und h3 liegt, ist dabei für einen Bereich zwischen gegenüberliegenden Stirnseiten eines Gehäuseteils charakteristisch. Dabei ist die Fig. 1b eine Ansicht auf eine der Stirnseiten b des Gehäuses 1 und zeigt die absolute Höhe h, welche das Gehäuse in einem zusammengebauten Zustand aufweist (die Höhe h ist daher nicht bis zur dargestellten Oberseite des Gehäuses angegeben, da das Gehäuse in nicht zusammengebautem Zustand gezeigt ist; ebenso in Fig. 2a; aus Fig. 4b geht eindeutiger hervor, welche Höhe mit dem Bezugszeichen h gekennzeichnet ist). Auch ist die Höhe hz angedeutet, welche ein Zwischengehäuseteil 30 aufweist. Im Gegensatz zu dem ersten und zweiten Gehäuseteil 1, 20 weist das Zwischengehäuseteil 30 in diesem Ausführungsbeispiel eine konstante Höhe hz auf.

In der Fig. 1a sind ferner Leiterplattenebenen 14, 24, 34 in den Gehäuseteilen 10, 20, 30 angedeutet. Die Leiterplattenebenen 14, 24, 34 sind zumindest annähernd parallel zu einer in der x-y-Ebene ausgerichteten Grundplatte bzw. Grundfläche G des Gehäuses 1 ausgerichtet. In dem ersten und zweiten Gehäuseteil 10, 20 ist jeweils eine Leiterplattenebene 14, 24 vorgesehen, und in einem Zwischengehäuseteil 30 sind zwei Leiterplattenebenen 34 vorgesehen. Die Leiterplattenebenen 14, 24, 34 können in einer bestimmten Höhe h2e vorgesehen sein. Am Beispiel des zweiten Gehäuseteils 20 ist dies nun kurz beschrieben: das zweite Gehäuseteil 20 weist eine geringste Höhe h1 (hier wie dargestellt ganz links an der linken Stirnseite) sowie eine größte Höhe h3 (hier wie dargestellt ganz rechts an der rechten Stirnseite) auf. Zwischen der linken und rechten Stirnseite ist eine sich in x-Richtung erstreckende Längsfläche A gebildet, und diese Längsfläche A erhält durch die winkelig verlaufende Teilstrecke 21a der Schnittstelle 21 eine teilweise dreiecksförmige Geometrie, d.h., die Geometrie eines Fünfecks, welches einer der Hälften eines entlang der Symmetrieachse unterteilten Trapezoids entspräche. Die Höhe h2e, in welcher die Leiterplattenebenen vorgesehen sein können, liegt bei den besonders vorteilhaften Ausführungsbeispielen der vorliegenden Erfindung betragsmäßig zwischen der geringsten Höhe h1 und der größten Höhe h3. Hierdurch kann sichergestellt werden, dass eine Leiterplatte (nicht dargestellt) gut zugänglich ist. In einer besonderen Ausführungsform kann eine Leiterplatteneben 14, 24 auch in einer Höhe angeordnet sein, die kleiner ist als die geringste Höhe h1.

In dem in den Fig. 1a, b gezeigten Ausführungsbeispiel sind Leiterplattenebenen für vier Leiterplatten vorgesehen, nämlich in dem ersten und zweiten Gehäuseteil 10, 20 jeweils für eine Leiterplatte, und in dem dritten Gehäuseteil 30 (Zwischengehäuseteil) Leiterplattenebenen für zwei Leiterplatten. Jede Leiterplatte ist gut zugänglich, denn auch in dem Zwischengehäuseteil 30 kann jede Leiterplatte so montiert und kontaktiert werden, dass deren Steckerseite weitgehend frei liegt und nicht von Wandungen umgrenzt wird. In der gezeigten Anordnung des Gehäuses würden die beiden Leiterplatten (nicht dargestellt) in dem Zwischengehäuseteil 30 in der oberen der Leiterplattenebenen 34 mit der Steckerseite nach rechts in x-Richtung ausgerichtet sein, wobei die elektronischen Komponenten nach oben in z-Richtung weisend auf der Leiterplatten angeordnet wären, und in der unteren der Leiterplattenebenen 34 mit der Steckerseite nach links entgegen der x-Richtung ausgerichtet sein, wobei die elektronischen Komponenten nach unten entgegen z-Richtung weisend auf der Leiterplatten angeordnet wären. Ein Stecker für die untere der in dem Zwischengehäuseteil 30 anzuordnenden Leiterplatten kann dann durch die Aussparung 13 des ersten Gehäuseteils 10 geführt werden.

Ein Gehäuse 1 weist im zusammengebauten Zustand zwei Längsseiten a und zwei Stirnseiten b und zwei Grundflächen G auf, wobei die Längsseiten a und die Stirnseiten b jeweils durch Längsflächen A und Stirnflächen B der einzelnen Gehäuseteile 10, 20, 30 gebildet sind.

In der Fig. 1a ist dargestellt, dass die Leiterplattenebene 14, 24 beabstandet von der Grundfläche G des jeweiligen Gehäuseteils 10, 20 ist. Um ein besonders flaches Gehäuse bereitzustellen, kann die Leiterplattenebene 14, 24 aber auch zumindest annähernd mit der Grundfläche G zusammenfallen.

In der Fig. 2a ist eine Seitenansicht auf eine Stirnseite b eines Gehäuses 1 mit einer Blickrichtung entgegen der x-Richtung gemäß einem zweiten Ausführungsbeispiel gezeigt. In der Fig. 2a bzw. 2b ist im Gegensatz zum ersten Ausführungsbeispiel gezeigt, dass die Leiterplattenebenen 14, 24, 34, 44 auch in einer Höhe h2e angeordnet sein können, welche etwas geringer ist als die Höhe einer Steckerseite 13a, 23a, 33aa, 33bb, 43aa, 43bb, d.h. der Stirnseite, an welcher ein Stecker vorzusehen ist. Dies kann z.B. dann vorteilhaft sein, wenn ein Stecker nicht auf der Ebene der Leiterplatte über die Leiterplatte hervorsteht, sondern erst in einer gewissen Höhe über der Leiterplatte. Dann kann durch die Anordnung der Leiterplatte(n) in einer Höhe h2e, welche kleiner ist als die Höhe der jeweiligen Steckerseite, ein Stecker auch durch die Unterkante der in der Steckerseite vorgesehenen Ausnehmung gehalten und ausgerichtet werden. Auch kann dann auf einfache Weise eine Abdichtung zwischen einem Stecker und dem jeweiligen Gehäuseteil erfolgen.

In der Fig. 2a sind ferner eine Aussparung 33a im ersten Kuppelbereich am dritten Gehäuseteil 30 sowie eine Aussparung 43a in einem ersten Kuppelbereich 41 am vierten Gehäuseteil 40 gezeigt. Das vierte Gehäuseteil 40 weist ferner, wie auch das dritte Gehäuseteil 30, einen zweiten Kuppelbereich 42 auf, wie in Fig. 2b gezeigt.

Zu den in Fig. 2b gezeigten Steckerseiten 13a, 23a, 33aa, 33bb, 43aa, 43bb ist noch zu erwähnen, dass diese jeweils an gegenüberliegenden Stirnseiten eines jeweiligen Zwischen.Gehäuseteils vorgesehen sind. Ein oberes und unteres Gehäuseteil 10, 20 weisen nur eine Steckerseite auf. In einem zusammengebauten Zustand des Gehäuses kann durch diesen Aufbau erreicht werden, dass bei nebeneinander angeordneten Leiterplatten die (Zentral-)Stecker jedenfalls an gegenüberliegenden Stirnseiten des Gehäuses angeordnet sind, wodurch Platz gespart werden kann, insbesondere eine geringe Bauhöhe erzielt werden kann. Ferner sind winkelig verlaufende Teilstrecken 32a, 41a, 42a gezeigt, welche zum einen eine Montage erleichtern, indem deutlich wird, in welcher Ausrichtung die Gehäuseteile aufeinander montiert werden sollen, und welche zum anderen die gute Zugänglichkeit zu in einem Gehäuseteil eingesetzten Leiterplatten sicherstellen.

Aus den Fig. 1a bis 2b ergibt sich, dass das Gehäuse 1 in Abhängigkeit der Anzahl an aufzunehmenden Leiterplatten eine bestimmte Höhe h aufweist, was in den Fig. 1b und 2a durch eine gestrichelte obere Linie angedeutet ist, welche in einem zusammengebauten Zustand mit der Oberseite des Gehäuses 1 in etwa zusammenfallen würde. Diese Höhe ist betragsmäßig in Bezug auf die Anzahl der Leiterplatten vergleichsweise gering, denn die Steckerseiten der Leiterplatten können wechselseitig an den gegenüberliegenden Stirnseiten des Gehäuses 1 angeordnet sein. Dies liefert den Vorteil geringer Bauhöhe des gesamten Gehäuses 1. Das gesamte Gehäuse 1 ist kaskadenartig aufgebaut und kann beliebig erweitert werden, ohne dass eine elektrische Kontaktierung von anderen Seiten als den Stirnseiten des Gehäuses 1 erforderlich ist.

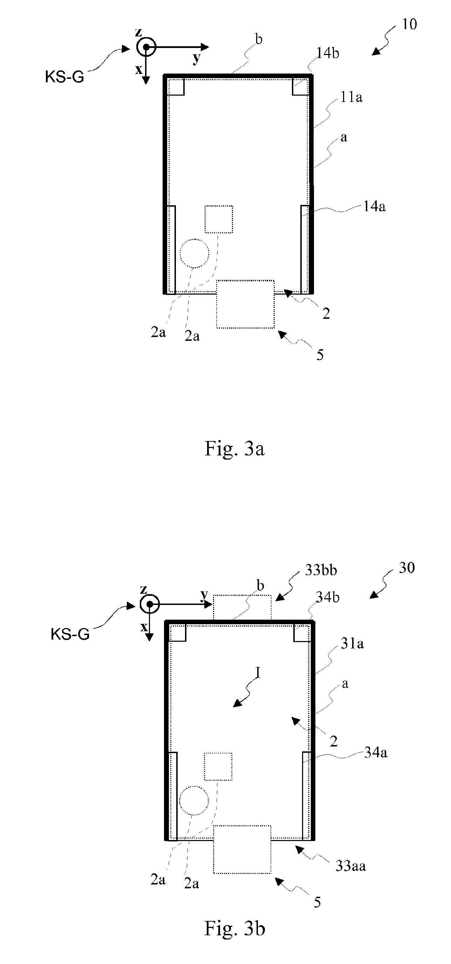

In den Fig. 3a ist ein erstes Gehäuseteil 10 gemäß der Fig. 1a,b in einer Draufsicht von oben auf das offene Gehäuseteil und in Fig. 3b ist ein Zwischengehäuseteil 30 gemäß der Fig. 1a,b in einer Draufsicht von oben gezeigt, und eine Leiterplatte 2 ist jeweils gestrichelt angedeutet (an welcher hier ein Stecker vorgesehen ist), und die Leiterplatte 2 ist in einer Leiterplattenebene angeordnet. Ferner ist schematisch angedeutet, dass das jeweilige Gehäuseteil 10, 30 gegenüber der Leiterplattenebene nur an drei von vier Seiten eine sich in z-Richtung erstreckende Wandung (an zwei Längsflächen und einer Stirnfläche) aufweist, hier durch die stärkere Strichstärke angedeutet. An der vierten Seite ist eine in z-Richtung über die Leiterplattenebene hinausragende Wandung nicht vorgesehen, so dass eine Leiterplatte auf einfache Weise über diese Seite montiert werden kann. Wie aus den Fig. 1a, b hervorgeht, sind die Leiterplattenebenen bei diesem Ausführungsbeispiel im Wesentlichen auf einer Höhe angeordnet, welche der Höhe der einen Stirnseite bzw. Steckerseite 13a, 33aa, 33bb entspricht. In der Leiterplattenebene können Aufnahmemittel 14a, 34a vorgesehen sein, z.B. in Form von Führungen, in welche eine Leiterplatte geschoben werden kann. Auch können in der Leiterplattenebene Befestigungsmittel 14b, 34b vorgesehen sein, z.B. in Form von Vorsprüngen, Hinterschneidungen, Einrastmitteln, oder Schlitzen. Eine winkelig verlaufende Teilstrecke 11a, 31a einer Schnittstelle 11, 31 des jeweiligen Gehäuseteils 10, 30 ist jeweils an den Längsseiten a vorgesehen.

In der Fig. 4a ist eine Seitenansicht auf eine Längsseite eines Gehäuses 1 mit einer Blickrichtung in x-Richtung gemäß dem dritten Ausführungsbeispiel gezeigt. In einem Zwischengehäuseteil 30 sind zwei Leiterplattenebenen 34 angedeutet. Auch in den beiden Gehäusedeckeln sind Leiterplattenebenen 14, 24 angedeutet. Die einzelnen Gehäuseteile sind über ihre jeweiligen Kuppelbereiche 11, 21, 31, 32 miteinander gekoppelt. Die Kuppelbereiche weisen jeweils einen schräg gegenüber der Grundfläche des Gehäuses verlaufenden Teilabschnitt auf. Aus dem Gehäuse stehen Stecker 5 hervor.

In der Fig. 4b ist eine Seitenansicht auf eine Stirnseite eines Gehäuses 1 mit einer Blickrichtung in x-Richtung gemäß dem dritten Ausführungsbeispiel gezeigt. Durch das Gehäuse geführte Stecker sind gestrichelt dargestellt. Das Gehäuse 1 ist im Bereich der Stecker, also im Kuppelbereich, durch eine Dichtung 15 gegenüber der Umgebung abgedichtet. Der obere der beiden schematisch angedeuteten Stecker ist durch eine Aussparung 33b in einem zweiten Kuppelbereich am dritten Gehäuseteil geführt. Das Gehäuse ist im zusammengebauten Zustand gezeigt und weist eine Höhe h auf.

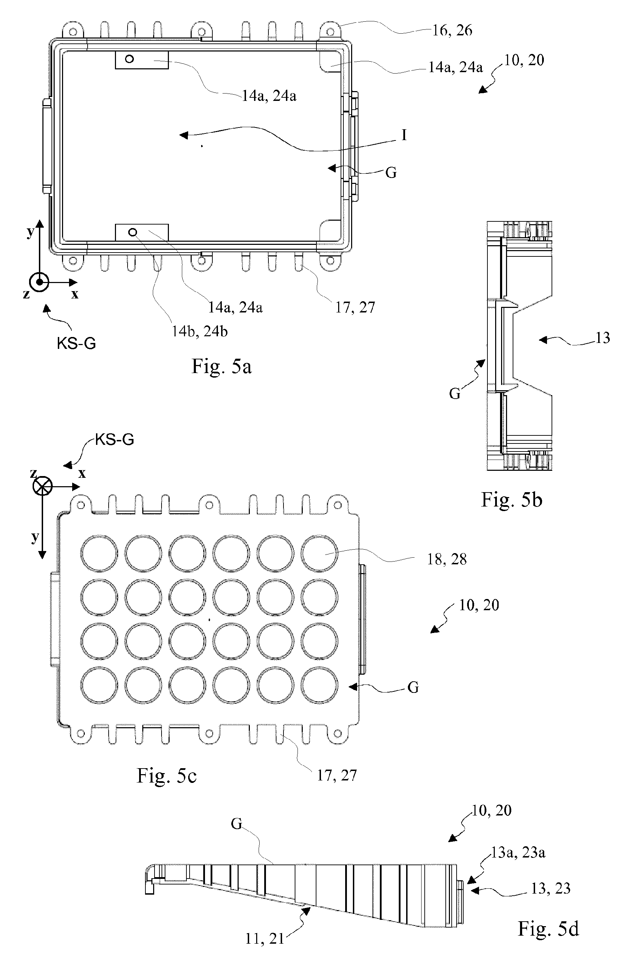

In der Fig. 5a ist in einer Draufsicht in einer Blickrichtung entgegen der z-Richtung ein Gehäuseteil 10 des Gehäuses 1 gemäß dem dritten Ausführungsbeispiel gezeigt, wobei das Gehäuseteil 10 das untenliegende erste Gehäuseteil 10 darstellt und der Blick eine Grundfläche G fällt, an welcher eine Leiterplatte angeordnet werden kann. Ferner ist ein Innenraum I angedeutet, welcher durch die seitlichen Wandungen des Gehäuseteils 10 gebildet wird, und welcher durch die schalenartige Form des Gehäuseteils 10 nach oben hin offen ist, so dass Bauteile, speziell Leiterplatten, leicht eingesetzt werden können. In dem Innenraum I sind Aufnahmemittel 14a vorgesehen, an welchen eine Leiterplatte fixierbar ist, z.B. über Befestigungsmittel 14b, hier in Form von Bohrungen angedeutet, die ein Innengewinde aufweisen können. In der Fig. 5a ist ferner gezeigt, dass die Aufnahmemittel 14a im Bereich der seitlichen Wandungen des Gehäuseteils 10 angeordnet sein können, speziell auch im Bereich von Kühlrippen 17, so dass eine Wärmeleitbrücke von einem Bauteil, speziell einer Leiterplatte, zu den Kühlrippen 17 vorgesehen sein kann, insbesondere wenn das Gehäuse 1 aus einem gut wärmeleitenden Material besteht. Das Gehäuseteil 10 kann als oberes oder unteres Gehäuseteil verwendet werden, was durch die sich auf ein zweites Gehäuseteil 20 beziehenden Bezugszeichen verdeutlicht ist.

In der Fig. 5b ist eine Seitenansicht auf eine Stirnseite des Gehäuseteils 10 mit einer Blickrichtung in x-Richtung gemäß dem dritten Ausführungsbeispiel des Gehäuses 1 gezeigt.

In der Fig. 5c ist in einer Ansicht in einer Blickrichtung in z-Richtung ein Gehäuseteil 10 des Gehäuses 1 gemäß dem dritten Ausführungsbeispiel gezeigt, wobei das Gehäuseteil 10 das untenliegende erste Gehäuseteil 10 darstellt und der Blick auf die Unterseite bzw. Grundfläche G fällt. Ferner ist in Fig. 5c erkennbar, dass an einer Grundfläche G des Gehäuseteils 10 Einbuchtungen 18 oder Ausnehmungen für einen optionalen Durchlass für BUS-Leitungen vorgesehen sein können. Auch können ein oder mehrere Durchlässe oder Ausnehmungen für eine andere Art von Steckern, auch Zentralstecker, vorgesehen sein, wobei eine Abdichtung der Stecker dann nicht über zwei Gehäuseteile erfolgt sondern in einem der Gehäuseteile vorgesehen sein kann. Die Anordnung der Einbuchtungen 18 an der Ober- bzw. Unterseite eines jeweiligen Gehäuseteils stellt sicher, dass die BUS-Leitungen gut zugänglich sind, und dass eine räumliche Trennung von den Haupt- bzw. Zentralsteckern auf einfache Weise möglich ist. Die Einbuchtungen 18 an der Gehäuseaußenseite können standardgemäß als in Bezug auf zu kontaktierende Leiterplatten angeordnete Bohrungen vorgesehen sein, welche als Durchgangsbohrung weitergebildet sein können. Solche Durchlässe können dazu ausgebildet sein, weitere Kontakte durch das Gehäuse unmittelbar an eine Leiterplatte zu führen, ohne dass das Gehäuse geöffnet werden muss.

In der Fig. 5d ist eine Seitenansicht in einer Blickrichtung entgegen der y-Richtung auf eine Längsseite des Gehäuseteils 10 gemäß dem dritten Ausführungsbeispiel des Gehäuses 1 gezeigt. Es ist gezeigt, dass die Steckerseite 13a derjenigen Stirnseite des Gehäuseteils 10 entspricht, welche die größere Höhe aufweist als die gegenüberliegende Stirnseite.

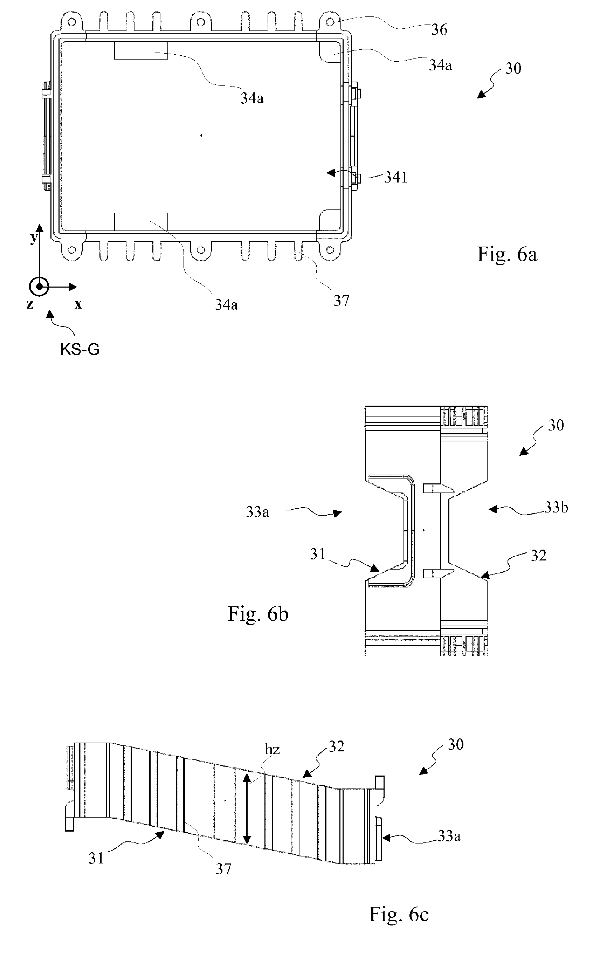

In der Fig. 6a ist in einer Draufsicht in einer Blickrichtung entgegen der z-Richtung ein Zwischengehäuseteil 30 eines Gehäuses gemäß dem dritten Ausführungsbeispiel gezeigt, wobei eine Zwischenwandung 341 vorliegt, an welcher ein oder mehrere Bauteile (nicht dargestellt) wie z.B. eine Leiterplatte angeordnet werden können, insbesondere beidseitig. Die Zwischenwandung 341 kann aus demselben Material wie die Wandungen des Zwischengehäuseteils 30 ausgeführt sein. Zur definierten Anordnung von Leiterplatten sind Aufnahmemittel 34a vorgesehen, an welchen eine Leiterplatte jeweils zur Anlage kommen kann. Durch die Ausgestaltung und Anordnung der Aufnahmemittel 34a können Ebenen definiert werden, in welchen Leiterplatten anzuordnen sind. An dem Zwischengehäuseteil 30 sind Kühlrippen 37 und Verbindungsbereiche 36 vorgesehen.

Bei diesem Ausführungsbeispiel des Zwischengehäuseteils 30 ist eine weitere Draufsicht, wie in Fig. 5a und 5c, auf die Grundfläche in entgegen gesetzter Richtung nicht erforderlich, da das Zwischengehäuseteil 30 symmetrisch aufgebaut ist.

In der Fig. 6b ist eine Seitenansicht in einer Blickrichtung in x-Richtung auf eine Stirnseite des Zwischengehäuseteils 30 gemäß dem dritten Ausführungsbeispiel des Gehäuses 1 gezeigt, wobei die Anordnung einer ersten Aussparung 33a in einem ersten Kuppelbereich 31 in Bezug auf die Anordnung einer zweiten Aussparung 33b in einem zweiten Kuppelbereich 32 deutlich wird.

In der Fig. 6c ist eine Seitenansicht in einer Blickrichtung entgegen der y-Richtung auf eine Längsseite des Zwischengehäuseteils 30 gemäß dem dritten Ausführungsbeispiel des Gehäuses 1 gezeigt, wobei erkennbar ist, dass die an einer Längsseite angeordneten Kühlrippen 37 sich von dem ersten Kuppelbereich 31 zu dem zweiten Kuppelbereich 32 erstrecken und im Wesentlichen dieselbe Länge aufweisen, da das Zwischengehäuseteil 30 eine einheitliche Höhe hz aufweist, welche sich in einer x-Richtung nicht verändert.

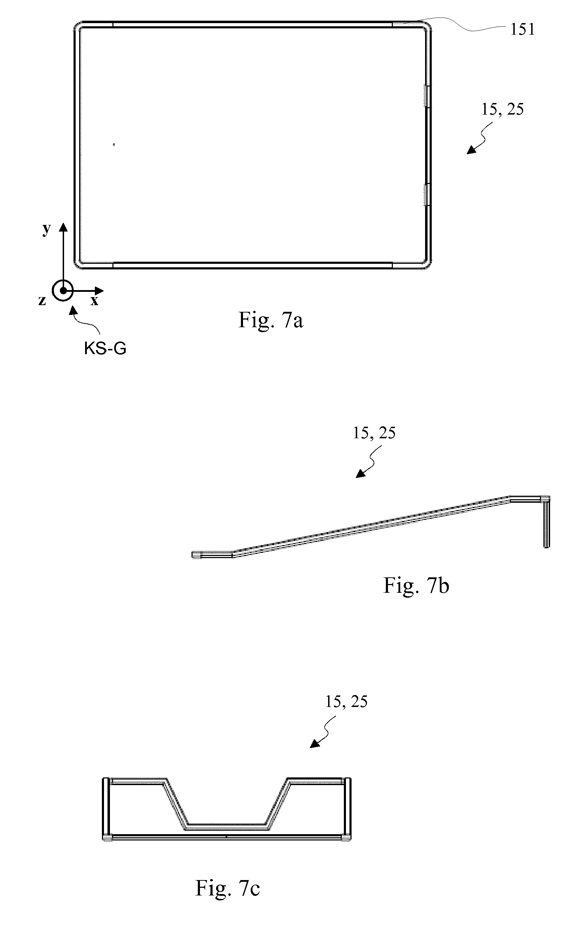

In der Fig. 7a ist in einer Draufsicht in einer Blickrichtung entgegen der z-Richtung eine Dichtung 15, 25 des Gehäuses gemäß dem dritten Ausführungsbeispiel gezeigt, wobei die Dichtung als umlaufender Formgummi 151 ausgebildet ist, welcher an die Kontur bzw. den Verlauf eines Kuppelbereichs an einem jeweiligen Gehäuseteil angepasst ist und diese Form in einem nicht verspannten bzw. nicht gestreckten oder gestauchten Zustand von Haus aus annimmt. Dies erleichtert eine Montage und stellt sicher, dass die Dichtung auch in der Wandstärke bereitgestellt werden kann, welche in einem jeweiligen Abschnitt eines Kuppelbereichs des Gehäuses erwünscht ist. Denn im Bereich der Aussparung, in welchem der Kuppelbereich einen winkeligen und kurvigen Verlauf aufweisen kann und zudem die Dichtung auch unmittelbar an einem Zentralstecker zur Anlage kommen kann, ist es wünschenswert, dass die Dichtung auch im eingebauten Zustand eine im Voraus definierbare Wandstärke aufweist. Dadurch kann die Dichtwirkung gezielter eingestellt werden, speziell in Verbindung mit einem gegenseitigen Verspannen der Gehäuseteile. Es ist zu erwähnen, dass die Dichtung 15, 25 auch für eine Abdichtung eines ersten oder zweiten Kuppelbereichs an einem dritten oder vierten Gehäuseteil vorgesehen sein kann.

In der Fig. 7b ist eine Seitenansicht in einer Blickrichtung in y-Richtung auf eine Längsseite der Dichtung 15, 25 gemäß dem dritten Ausführungsbeispiel des Gehäuses gezeigt, und in der Fig. 7c ist eine Seitenansicht in einer Blickrichtung in x-Richtung auf eine Stirnseite der Dichtung 15, 25 gezeigt.

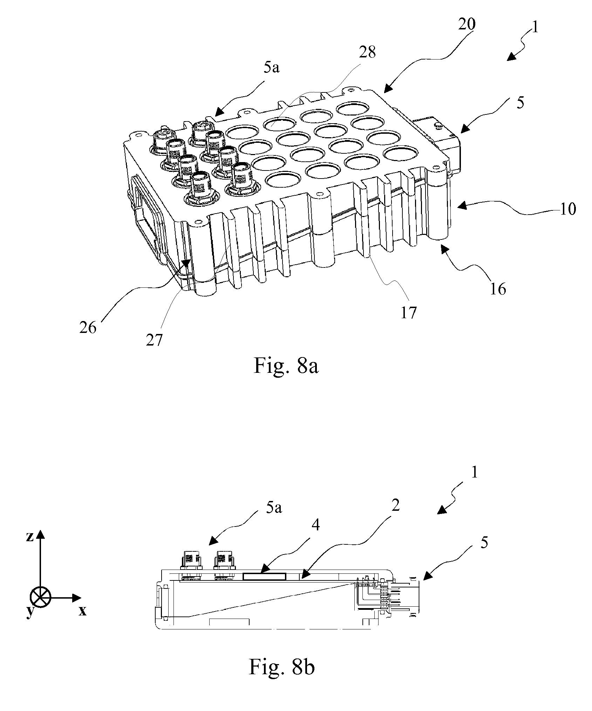

Die Fig. 8a, 9a, 9b, 10a, 10b, 11a, 11b, 12a, 12b, 13a, 13b, 14a, 14b zeigen verschiedene Varianten eines Gehäuses 1 gemäß einem vierten, fünften, sechsten, siebten, achten, neunten und zehnten Ausführungsbeispiel, wobei jeweils hervorgehoben ist, auf welche Weise Leiterplatten in dem Gehäuse angeordnet und mit Steckern kontaktiert werden können.

Speziell die Fig. 8a, b zeigen ein Gehäuse 1 gemäß einem vierten Ausführungsbeispiel, bei welchem einige Steckeranschlüsse 5a, speziell für M12-Verbindungen, auf einer Rückseite einer Master-Leiterplatte 2 und ein Zentralstecker 5 vorgesehen sind. Ferner sind Verbindungsbereiche 16, 26 und Kühlrippen 17, 27 sowie Einbuchtungen 28 vorgesehen, speziell auch an einem zweiten Gehäuseteil 20. Ferner können Mittel zum Wärmeleiten 4 optional vorgesehen sein, z.B. zwischen einer Grundfläche und einer Leiterplatte, und welche ein Abführen von Wärme verbessern können. Die Mittel zum Wärmeleiten können als Folie oder Paste oder auch als Strangpressprofil ausgebildet sein, auch als eine Kombination daraus, und auch oberhalb einer Leiterplatte angeordnet sein.

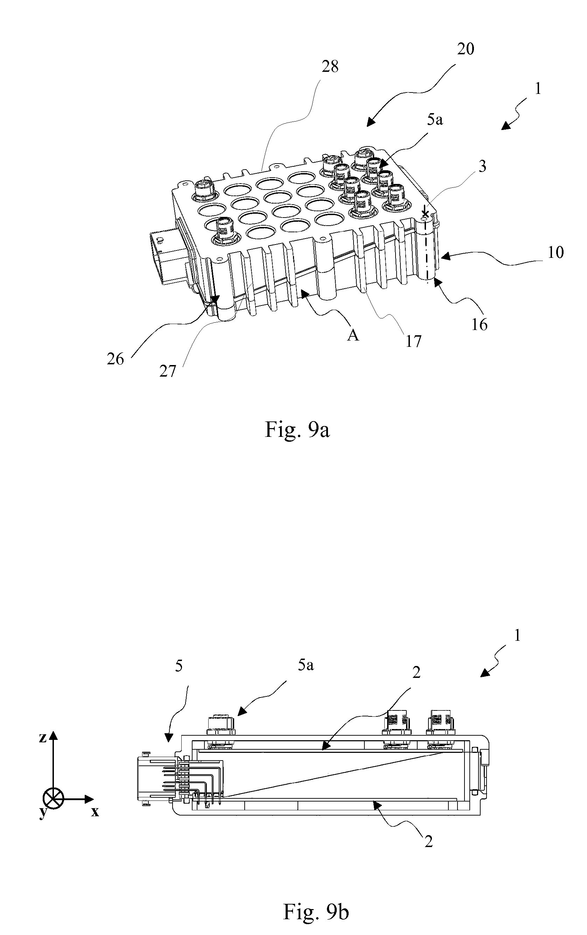

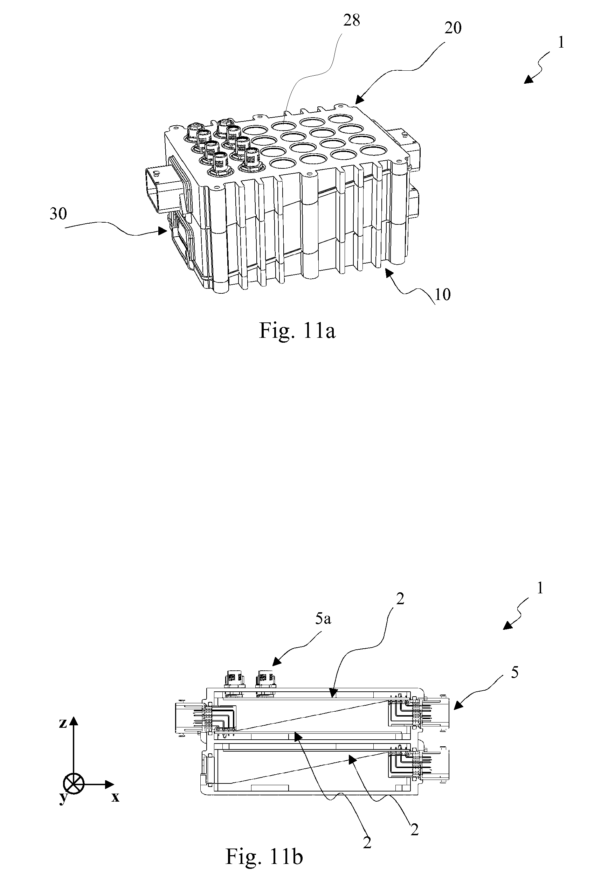

Die Fig. 9a, b zeigen ein Gehäuse 1 gemäß einem fünften Ausführungsbeispiel, bei welchem M12-Steckverbinder 5a auf einer oben in einem zweiten Gehäuseteil 20 angeordneten Erweiterungs-Leiterplatte 2 sowie ein Zentralstecker 5 auf einer unten in einem ersten Gehäuseteil 10 angeordneten Master-Leiterplatte 2 vorgesehen sind. Die Leiterplatten 2 sind intern verbunden. Außen am Gehäuse 1 sind Kühlrippen 17 vorgesehen, welche durch beide Gehäuseteile gebildet sind und sich entlang der Längsfläche A des Gehäuses 1 über die Höhe des Gehäuses erstrecken. Auch sind Verbindungsbereiche 16 vorgesehen, sich entlang der Längsfläche A des Gehäuses 1 über die Höhe des Gehäuses erstrecken. Dadurch kann das Gehäuse 1 durch Verspannen der einzelnen Gehäuseteile gegeneinander gebildet werden. Für ein Verbinden oder Verspannen können Verbindungsmittel 3 vorgesehen sein, z.B. Schrauben, welche entlang aller Gehäuseteile geführt werden, selbst wenn Zwischengehäuseteile (vgl. Fig. 11a) vorgesehen sind, oder welche zumindest jeweils in ein benachbartes Gehäuseteil eingreifen.

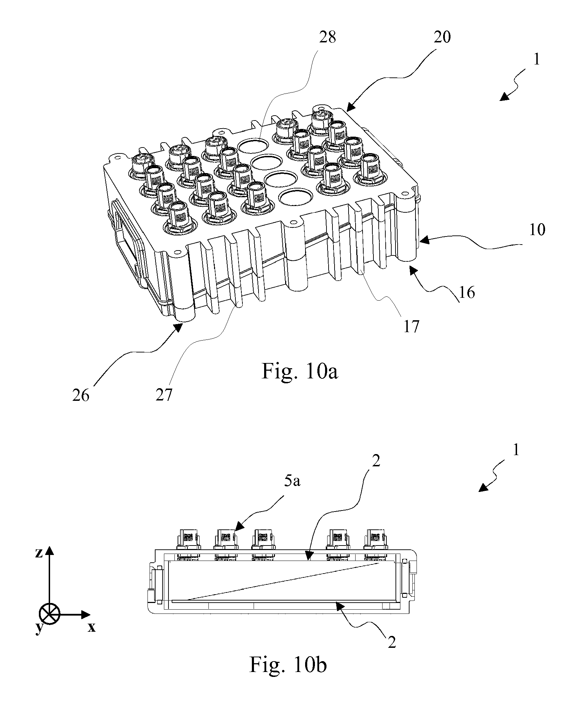

Die Fig. 10a, b zeigen ein Gehäuse 1 gemäß einem sechsten Ausführungsbeispiel, welches im Wesentlichen durch die Komponenten des Gehäuses gemäß dem fünften Ausführungsbeispiel gebildet ist, und bei welchem Steckverbinder 5a auf einer oben in einem zweiten Gehäuseteil 20 angeordneten Erweiterungs-Leiterplatte 2 sowie eine unten in einem ersten Gehäuseteil 10 angeordnete Master-Leiterplatte 2 vorgesehen sind. Die Leiterplatten 2 sind intern verbunden.

Die Fig. 11a, b zeigen ein Gehäuse 1 gemäß einem siebten Ausführungsbeispiel, bei welchem Steckverbinder 5a auf einer oben in einem zweiten Gehäuseteil 20 angeordneten Master-Leiterplatte 2 sowie zwei mittig in einem dritten Gehäuseteil 30, welches als Zwischen-Gehäuseteil ausgebildet ist, angeordnete Erweiterungs-Leiterplatten 2 vorgesehen sind. An der Master-Leiterplatte 2 und auch an den Erweiterungs-Leiterplatten 2 sind (Zentral-)Stecker 5 vorgesehen. Dabei kann auch in einem ersten Gehäuseteil 10 eine weitere Leiterplatte 2 vorgesehen sein. Dieses System kann somit mit maximal drei Erweiterungs-Leiterplatten ausgebaut werden.

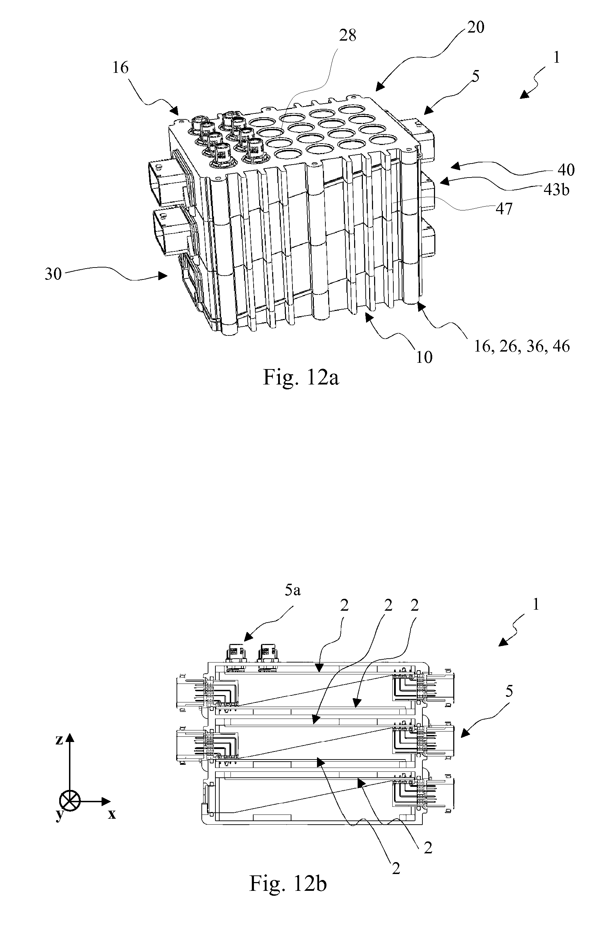

Die Fig. 12a, b zeigen ein Gehäuse 1 gemäß einem achten Ausführungsbeispiel, bei welchem M12-Stecker 5a auf einer oben in einem zweiten Gehäuseteil 20 angeordneten Master-Leiterplatte 2 sowie jeweils zwei mittig in einem dritten Gehäuseteil 30 und einem vierten Gehäuseteil 40 angeordnete Erweiterungs-Leiterplatten 2 vorgesehen sind, wobei das dritte und vierte Gehäuseteil als Zwischen-Gehäuseteile ausgebildet sind. An der Master-Leiterplatte 2 und auch an den Erweiterungs-Leiterplatten 2 sind (Zentral-)Stecker 5 vorgesehen. Dabei kann auch in einem ersten Gehäuseteil 10 eine weitere Leiterplatte 2 vorgesehen sein. Dieses System kann somit mit maximal fünf Erweiterungs-Leiterplatten ausgebaut werden.

Ferner sind in Fig. 12a Kühlrippen 47 sowie Verbindungsbereiche 46 an einem vierten Gehäuseteil 40 angedeutet, welche mit den Kühlrippen sowie Verbindungsbereichen der anderen Gehäuseteile zusammenfallen. Damit kann unabhängig von der Anzahl an Zwischengehäuseteilen 30, 40 ein einheitlich aufgebautes Gehäuse 1 bereitgestellt werden, welches sich verspannen lässt, z.B. mittels Schrauben, welche durch Verbindungsbereiche 16, 26, 36, 46 an allen Gehäuseteilen geführt sind. Dabei ist auch angedeutet, in welchem Bereich sich eine Aussparung 43b in einem zweiten Kuppelbereich am vierten Gehäuseteil bzw. Zwischengehäuseteil 40 befindet.

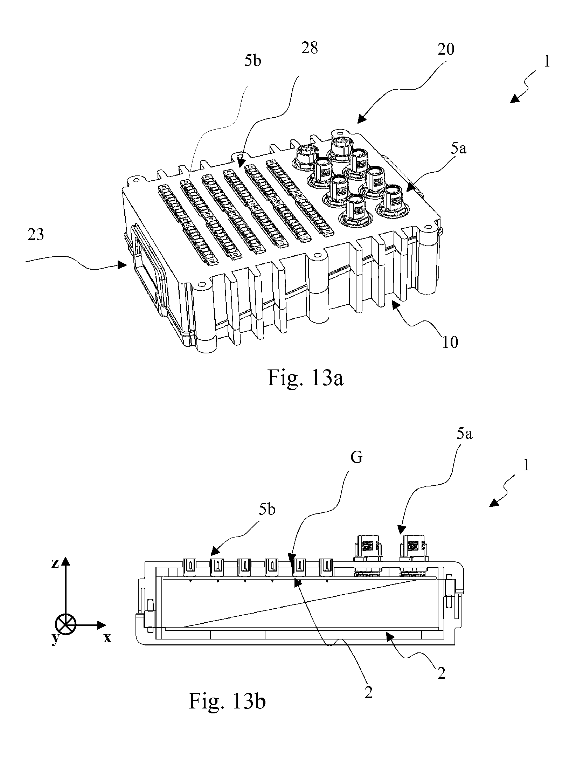

Die Fig. 13a, b zeigen ein Gehäuse 1 gemäß einem neunten Ausführungsbeispiel, bei welchem M12-Steckverbindern 5a und IP20-Stecker 5b auf einer in einem zweiten Gehäuseteil 20 angeordneten Erweiterungs-Leiterplatte 2 vorgesehen sind, wobei eine Master-Leiterplatte 2 unten in einem ersten Gehäuseteil 10 angeordnet ist. Die Leiterplatten 2 sind intern miteinander verbunden. Die als Durchlässe weitergebildeten Einbuchtungen 28 können somit spezifisch in Bezug auf einen bestimmten Steckertyp ausgebildet sein. Sie müssen also nicht notwendigerweise eine runde Form (vgl. Fig. 12a) aufweisen. In Fig. 13b wird deutlich, dass durch die Anordnung der Leiterplatte 2 nahe einer Grundfläche G des Gehäuses auch IP20-Steckkontakte durch das Gehäuse geführt werden können.

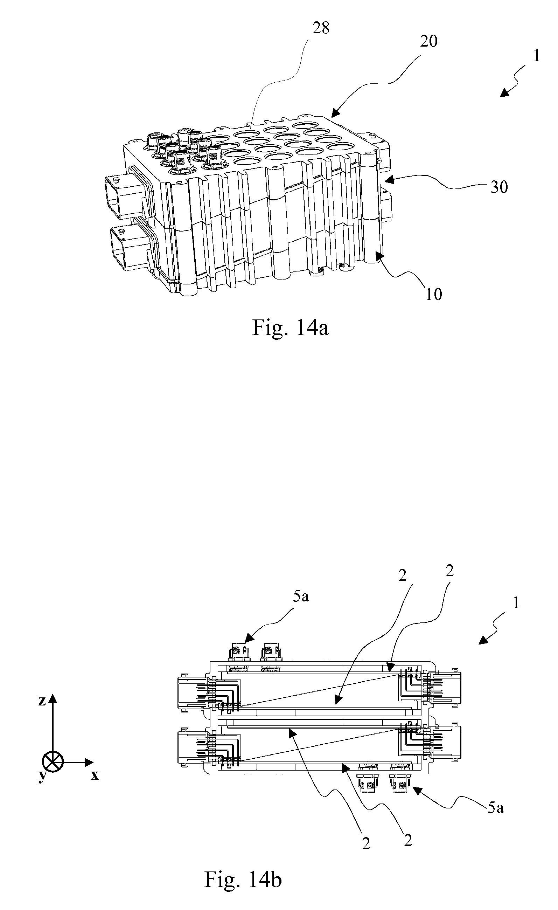

Die Fig. 14a, b zeigen ein Gehäuse 1 gemäß einem zehnten Ausführungsbeispiel, bei welchem jeweils M12-Stecker 5a und ein Zentralstecker 5 sowohl auf einer oben in einem zweiten Gehäuseteil 20 angeordneten Master-Leiterplatte 2 als auch auf einer unten in einem ersten Gehäuseteil 10 angeordneten Master-Leiterplatte 2 vorgesehen sind. Dieses System besitzt zwei Master-Leiterplatten 2 und kann variabel mit Erweiterungs-Leiterplatten 2 ausgebaut werden. Das System kann z.B. mit einem oder weiteren Zwischen-Gehäuseteilen 30 kaskadenartig erweitert werden, wobei jeweils ein oder zwei mittig in einem jeweiligen Zwischen-Gehäuseteil 30 angeordnete Erweiterungs-Leiterplatten 2 vorgesehen sein können. Die Leiterplatten 2 können intern verbunden werden.

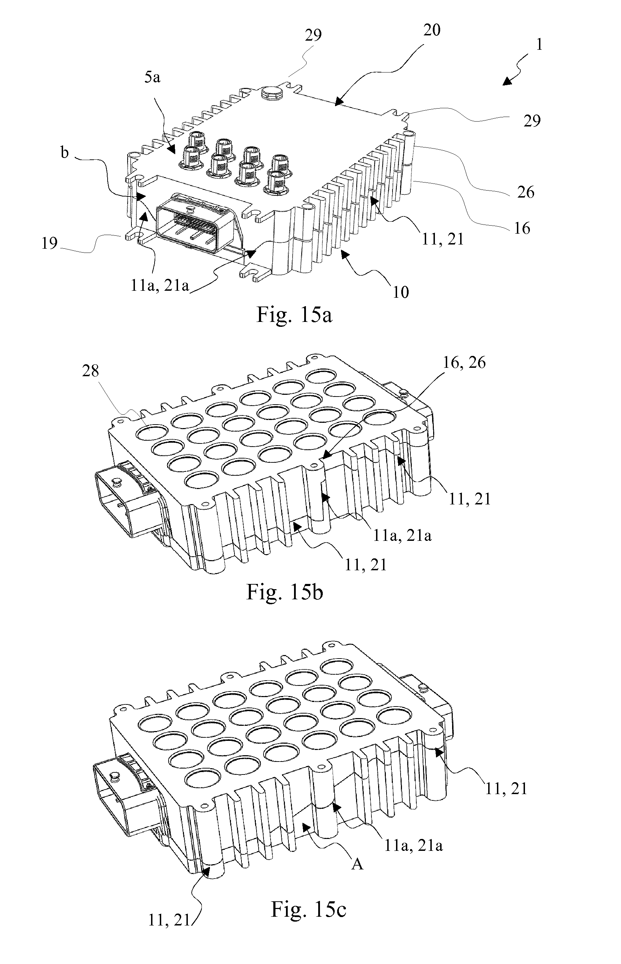

In der Fig. 15a ist ein elftes Ausführungsbeispiel der Erfindung gezeigt, bei welchem ein erstes 10 und ein zweites Gehäuseteil 20 vorgesehen sind, wobei die beiden Gehäuseteile jeweils vier miteinander fluchtende Verbindungsbereiche 16, 26 aufweisen. An dem oberen zweiten Gehäuseteil 20 sind acht weitere Stecker-Kontakte 5a vorgesehen, z.B. M12-Stecker für BUS-Verbindungen, und die entsprechenden Durchführungen. Zudem weist jedes Gehäuseteil 10, 20 an den Stirnseiten hervorstehende Rastnasen 19, 29 oder allgemein Flansche auf, über welche das Gehäuse 1 an einem Maschinenträger, Fahrzeug oder dergleichen befestigt werden kann. Die beiden Gehäuseteile 10, 20 weisen einen geradlinig verlaufenden Kuppelbereich 11,21 auf, d.h., eine winkelig verlaufende Teilstrecke ist an den Längsseiten nicht vorgesehen, vielmehr liegt sie hier an einer jeweiligen Stirnseite vor.

In der Fig. 15b ist ein zwölftes Ausführungsbeispiel der Erfindung gezeigt, bei welchem die beiden Gehäuseteile sowohl einen geradlinig verlaufenden Kuppelbereich 11, 21 als auch als Teil davon eine winkelig verlaufende Teilstrecke 11a, 21 a aufweisen, wobei die winkelig verlaufende Teilstrecke 11a, 21a im Bereich von miteinander fluchtenden Verbindungsbereichen 16, 26 vorgesehen ist und im Wesentlichen orthogonal zu dem geradlinig verlaufenden Kuppelbereich verlaufen. Dadurch kann ein Zusammensetzen der Gehäuseteile und ein Ausrichten der Verbindungsbereiche 16, 26 aufeinander auf einfache Weise erfolgen. Ferner weisen die Gehäuseteile eine Vielzahl von Einbuchtung 28 für einen optionalen Durchlass für weitere Stecker auf.

In der Fig. 15c ist ein dreizehntes Ausführungsbeispiel der Erfindung gezeigt, welches im Wesentlichen dieselben Merkmale wie das zwölfte Ausführungsbeispiel aufweist, nur dass die winkelig verlaufende Teilstrecke 11a, 21 a nicht allein im Bereich von miteinander fluchtenden Verbindungsbereichen vorgesehen ist, sondern über eine Länge von etwa 1/3 bis 2/3 der gesamten Länge der Längsfäche A des Gehäuses ausgebildet ist und dabei einen spitzen Winkel mit dem restlichen geradlinig verlaufenden Kuppelbereich 11,21 bildet, je nach Höhe des Gehäuses z.B. im Bereich von etwa 20 bis 60 Grad. Durch diese schräg verlaufende Schnittstelle kann die Montage der Gehäuseteile oder auch die Montage von Leiterplatten in den Gehäuseteilen erleichtert werden.

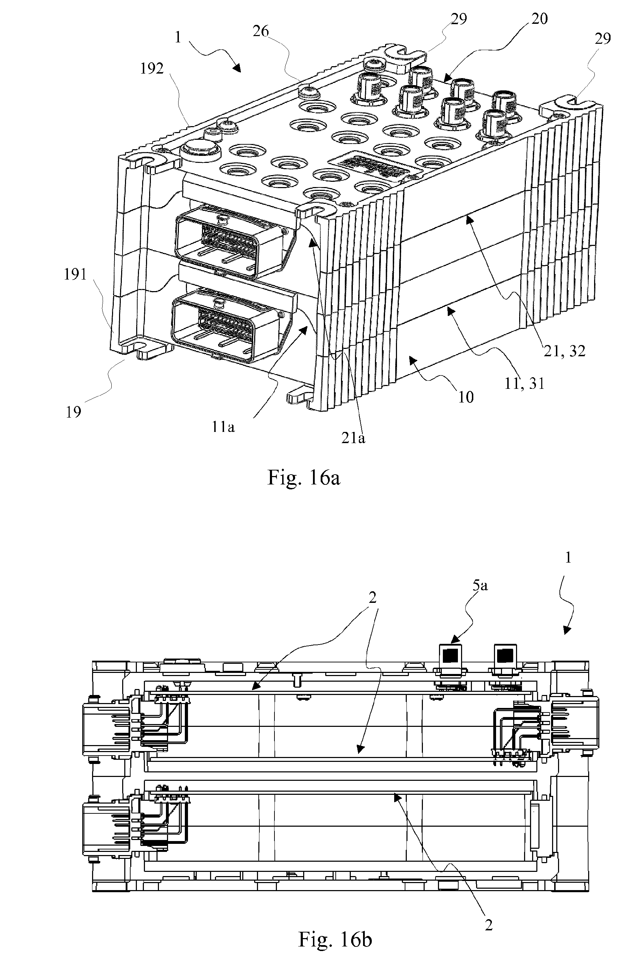

In der Fig. 16a ist ein Gehäuse 1 gezeigt, welches einen Kuppelbereich 11, 31; 21, 32 ohne Schrägen an den Längsflächen aufweist. Im Gegensatz zu vorher gezeigten Ausführungsbeispielen sind Schrägen 11a, 21 a an einer Stirnfläche vorgesehen, nämlich neben den Aussparungen für die Hauptstecker. Hierdurch ergibt sich der Vorteil, dass an den Längsseiten überall dieselben Entformungsschrägen vorgesehen sein können, was die Herstellung bei Druckgussteilen erleichtert. Kühlrippen sind nicht vorgesehen, wahlweise können in Bereichen der Längsseiten oder komplett an den Längsseiten Wellungen oder irgendein Profil zur Vergrößerung der Oberfläche vorgesehen sein. Ferner weist das Gehäuse 1 einen vorspringenden Rand 191 sowie einen überstehenden Rand 192 auf. Der Rand kann als Überhang bezeichnet werden. Der vorspringende Rand 191 dient insbesondere als Schutz für den Hauptstecker, und der überstehende Rand 192 kann so hoch ausgebildet sein, dass er gleichermaßen als Schutz für die BUS-Stecker dient. Hierdurch kann die Oberfläche zur Wärmeabstrahlung und Konvektion vergrößert werden. Fehlende Kühlrippen erfordern aber nicht notwendiger Weise einen Rand. Im Gegensatz zu vorher gezeigten Ausführungsbeispielen sind Verbindungsbereiche nicht außen am Gehäuse 1 sondern innen an den Längsseiten vorgesehen. In den Verbindungsbereichen 26 können als Verbindungsmittel selbstschneidende oder selbstformende Schrauben vorgesehen sein. Hier sind selbstformende Schrauben vorgesehen, welche auch mehrmals in ein Gewinde eingeschraubt werden können, so dass eine wiederholte Montage möglich ist. Dabei ist eine stufenweise Verschraubung einzelner Gehäuseteile oder auch eine Verschraubung aller Gehäuseteile mit durchgehenden Schrauben möglich.

Schließlich zeigt Fig. 16b in einer Schnittansicht drei in dem Gehäuse 1 angeordnete Leiterplatten 2 mit einem jeweiligen Hauptstecker, und an einer Oberseite sind weitere Stecker-Kontakte 5a vorgesehen.

### Bezugszeichenliste

- 1: Gehäuse
- 2: Leiterplatte
- 2a: Bauteil auf Leiterplatte

- 3: Verbindungsmittel

- 4: Mittel zum Wärmeleiten (z.B. Wärmeleitfolie)

- 5: (Zentral-)Stecker an Leiterplatte
- 5a: weiterer Stecker-Kontakt, z.B. M12-Stecker für BUS-Verbindungen
- 5b: weiterer Stecker-Kontakt, z.B. IP20-Stecker

- 10: erstes Gehäuseteil
- 11: Kuppelbereich (Schnittstelle) am ersten Gehäuseteil
- 11a: winkelig verlaufende Teilstrecke des Kuppelbereichs am ersten Gehäuseteil
- 13: Aussparung im Kuppelbereich am ersten Gehäuseteil
- 13a: Steckerseite des ersten Gehäuseteils
- 14: Leiterplattenebene im ersten Gehäuseteil
- 14a: Aufnahmemittel in der Leiterplattenebene im ersten Gehäuseteil
- 14b: Befestigungsmittel in der Leiterplattenebene im ersten Gehäuseteil
- 15: Dichtung im Kuppelbereich am ersten Gehäuseteil
- 151: umlaufender Formgummi
- 16: Verbindungsbereich am ersten Gehäuseteil
- 17: Kühlrippe am ersten Gehäuseteil
- 18: Einbuchtung für einen optionalen Durchlass für weitere Stecker
- 19: Rastnase
- 191: vorspringender Rand
- 192: überstehender Rand

- 20: zweites Gehäuseteil
- 21: Kuppelbereich (Schnittstelle) am zweiten Gehäuseteil
- 21a: winkelig verlaufende Teilstrecke des Kuppelbereichs am zweiten Gehäuseteil
- 23: Aussparung im Kuppelbereich am zweiten Gehäuseteil
- 23a: Steckerseite des zweiten Gehäuseteils
- 24: Leiterplattenebene im zweiten Gehäuseteil
- 24a: Aufnahmemittel in der Leiterplattenebene im zweiten Gehäuseteil
- 24b: Befestigungsmittel in der Leiterplattenebene im zweiten Gehäuseteil
- 25: Dichtung im Kuppelbereich am zweiten Gehäuseteil
- 26: Verbindungsbereich am zweiten Gehäuseteil
- 27: Kühlrippe am zweiten Gehäuseteil
- 28: Einbuchtung für einen optionalen Durchlass für weitere Stecker
- 29: Rastnase

- 30: drittes Gehäuseteil
- 31: erster Kuppelbereich (Schnittstelle) am dritten Gehäuseteil
- 31a: winkelig verlaufende Teilstrecke des ersten Kuppelbereichs am dritten Gehäuseteil
- 32: zweiter Kuppelbereich am dritten Gehäuseteil
- 32a: winkelig verlaufende Teilstrecke des zweiten Kuppelbereichs am dritten Gehäuseteil
- 33a: Aussparung im ersten Kuppelbereich am dritten Gehäuseteil
- 33aa: erste Steckerseite des dritten Gehäuseteils
- 33b: Aussparung im zweiten Kuppelbereich am dritten Gehäuseteil
- 33bb: zweite Steckerseite des dritten Gehäuseteils
- 34: Leiterplattenebenen im dritten Gehäuseteil
- 34a: Aufnahmemittel in den Leiterplattenebenen im dritten Gehäuseteil
- 34b: Befestigungsmittel in den Leiterplattenebenen im dritten Gehäuseteil
- 341: Zwischenwandung in dem dritten Gehäuseteil
- 36: Verbindungsbereich am dritten Gehäuseteil
- 37: Kühlrippe am dritten Gehäuseteil

- 40: viertes Gehäuseteil
- 41: erster Kuppelbereich (Schnittstelle) am vierten Gehäuseteil
- 41a: winkelig verlaufende Teilstrecke des ersten Kuppelbereichs am vierten Gehäuseteil
- 42: zweiter Kuppelbereich (Schnittstelle) am vierten Gehäuseteil
- 42a: winkelig verlaufende Teilstrecke des zweiten Kuppelbereichs am vierten Gehäuseteil
- 43a: Aussparung im ersten Kuppelbereich am vierten Gehäuseteil
- 43aa: erste Steckerseite des vierten Gehäuseteils
- 43b: Aussparung im zweiten Kuppelbereich am vierten Gehäuseteil
- 43bb: zweite Steckerseite des vierten Gehäuseteils
- 44: Leiterplattenebenen im vierten Gehäuseteil
- 46: Verbindungsbereich am vierten Gehäuseteil
- 47: Kühlrippe am vierten Gehäuseteil

- A: Längsfläche des Gehäuses
- a: Längsseite des Gehäuses
- B: Stirnfläche des Gehäuses
- b: Stirnseite des Gehäuses
- G: Grundfläche des Gehäuses
- h: Höhe des Gehäuses
- h1: geringste Höhe des ersten bzw. zweiten Gehäuseteils
- h2: eine bestimmte Höhe, die betragsmäßig zwischen h1 und h3 liegt
- h2e: Höhe, in welcher eine Leiterplattenebene vorgesehen ist
- h3: größte Höhe des ersten bzw. zweiten Gehäuseteils
- hz: Höhe des dritten oder eines weiteren Gehäuseteils
- I: Innenraum
- KS-G: Koordinatensystem Gehäuse

## Patentansprüche

1. Gehäuse (1) zur Aufnahme elektronischer Bauteile (2), wobei das Gehäuse ein erstes und ein zweites Gehäuseteil (10, 20) aufweist, welche ein Gehäuseoberteil und ein Gehäuseunterteil mit jeweils einem Kuppelbereich (11, 21) bilden, und welche über ihren jeweiligen Kuppelbereich miteinander kuppelbar sind, wobei die Gehäuseteile jeweils eine Gehäusegrundfläche (G) aufweisen und in einem zusammengebauten Zustand einen zur platzsparenden Umgrenzung der Bauteile ausgelegten Innenraum (I) bilden, wobei das Gehäuse Aufnahmemittel (14a, 24a) zur definierten Anordnung der Bauteile aufweist, wobei jedes Gehäuseteil zur Aufnahme mindestens eines Bauteils vorgesehen ist, wobei die Aufnahmemittel (14a, 24a) in jedem Gehäuseteil vorgesehen sind,
**dadurch gekennzeichnet dass**
jedes Gehäuseteil im Kuppelbereich eine Aussparung (13, 23) in der vertikalen Außenwand des Gehäuseteils aufweist, welche in einem zusammengebauten Zustand des Gehäuses zusammen mit dem Kuppelbereich eines benachbarten Gehäuseteils jeweils eine Durchführung von Innen nach Außen für einen Stecker bildet, und
die Aussparung (13, 23) für einen Stecker des in dem ersten Gehäuseteil (10) vorzusehenden Bauteils in dem zweiten Gehäuseteil (20) vorgesehen ist.

2. Gehäuse nach Anspruch 1, **dadurch gekennzeichnet, dass** die Aufnahmemittel in einer Ebene (14, 24) zur Aufnahme der Bauteile angeordnet sind und im Bereich der Grundfläche (G) eines jeweiligen Gehäuseteils vorgesehen sind.

3. Gehäuse nach einem der vorhergehenden Ansprüche, wobei die Gehäuseteile eine an die aufzunehmenden Bauteile angepasste Geometrie aufweisen, so dass bei im Wesentlichen rechteckig ausgebildeten Bauteilen im zusammengebauten Zustand ein im Wesentlichen quaderförmiges Gehäuse mit zwei Längsseiten (a) und zwei Stirnseiten (b) und einer spezifischen Höhe (h) gebildet ist,
**dadurch gekennzeichnet, dass** die Aussparung in dem ersten Gehäuseteil und die Aussparung in dem zweiten Gehäuseteil an gegenüberliegenden Stirnseiten angeordnet sind.

4. Gehäuse nach einem der vorhergehenden Ansprüche, **dadurch gekennzeichnet, dass** die Gehäuseteile jeweils zwei Stirnseiten mit unterschiedlich großen Stirnflächen (B) aufweisen, und dass die Aussparung jeweils an der Stirnseite (b) mit der jeweils größeren Stirnfläche vorgesehen ist.

5. Gehäuse nach einem der vorhergehenden Ansprüche 2 bis 4, **dadurch gekennzeichnet, dass** der Kuppelbereich eines jeweiligen Gehäuseteils umlaufend ist und jeweils an Längsseiten (a) des Gehäuses entweder parallel zur Grundfläche (G) oder zumindest über eine Teilstrecke in einem Winkel gegenüber der Grundfläche (G) verläuft.

6. Gehäuse nach einem der vorhergehenden Ansprüche, **dadurch gekennzeichnet, dass** das erste und zweite Gehäuseteil schalenartig ausgebildet sind, und dass das Gehäuse ein drittes Gehäuseteil (30) in Form eines Zwischengehäuseteils mit zwei gegenüberliegenden Kuppelbereichen (31, 32) aufweist, welches in einem zusammengebauten Zustand zwischen dem ersten und zweiten Gehäuseteil angeordnet ist, und welches im jeweiligen Kuppelbereich eine Aussparung (33a,33b) für einen elektrischen Stecker aufweist, wobei die Aussparungen an gegenüberliegenden Stirnseiten (b) des Zwischengehäuseteils angeordnet sind, und wobei das Zwischengehäuseteil symmetrisch in Bezug auf zwei in dem Zwischengehäuseteil vorgesehenen Ebenen (34) zur Aufnahme von Bauteilen ausgeführt ist.

7. Gehäuse (1) nach einem der Ansprüche 1 bis 6, **dadurch gekennzeichnet, dass** eine Dichtung (15, 25) in dem Kuppelbereich (11, 21, 31, 32) jedes Gehäuseteils (10, 20, 30) vorgesehen ist, so dass in einem zusammengebauten Zustand des Gehäuses (1) in dem jeweiligen Kuppelbereich zwei Dichtungen (15, 25) aufeinanderliegen.

8. Gehäuse (1) nach Anspruch 7, **dadurch gekennzeichnet, dass** die Dichtung (15, 25) eine an den Kuppelbereich (11, 21, 31, 32) des jeweiligen Gehäuseteils (10, 20, 30) angepasste Form aufweist.

## Claims

1. Housing (1) for accommodating electronic components (2), wherein the housing has a first and a second housing part (10, 20), which first and second housing parts form a housing upper part and a housing lower part with a respective coupling region (11, 21) and which first and second housing parts can be coupled to one another by means of their respective coupling region, wherein the housing parts each have a housing base area (G) and, in an assembled state, form an interior (I) which is designed for bordering the components in a space-saving manner, wherein the housing has accommodation means (14a, 24a) for defined arrangement of the component, wherein each housing part is provided for accommodating at least one component, wherein the accommodation means (14a, 24a) are provided in each housing part,
**characterized in that**
each housing part has, in the coupling region, a cutout (13, 23) in the vertical outer wall of the housing part, which cutout, together with the coupling region of an adjacent housing part, forms a respective bushing from the inside to the outside for a plug in an assembled state of the housing, and
the cutout (13, 23) is provided for a plug of the component in the second housing part (20), which component is to be provided in the first housing part (10) .

2. Housing according to Claim 1, **characterized in that** the accommodation means are arranged in a plane (14, 24) for accommodating the components and are provided in the region of the base area (G) of a respective housing part.

3. Housing according to either of the preceding claims, wherein the housing parts have a geometry which is matched to the components which are to be accommodated, so that, for substantially rectangular components, a substantially cuboidal housing with two longitudinal sides (a) and two end sides (b) and a specific height (h) is formed in the assembled state, **characterized in that** the cutout in the first housing part and the cutout in the second housing part are arranged on opposite end sides.

4. Housing according to one of the preceding claims, **characterized in that** the housing parts each have two end sides with different end areas (B), and **in that** the cutout is respectively provided on that end side (b) with the respectively larger end area.

5. Housing according to one of the preceding Claims 2 to 4, **characterized in that** the coupling region of a respective housing part is circumferential and in each case runs on longitudinal sides (a) of the housing either parallel to the base area (G) or at least over a subsection at an angle in relation to the base area (G).

6. Housing according to one of the preceding claims, **characterized in that** the first and second housing parts are of tray-like design, and **in that** the housing has a third housing part (30) in the form of an intermediate housing part comprising two opposite coupling regions (31, 32), which third housing part is arranged between the first and second housing parts in an assembled state, and which third housing part has a cutout (33a, 33b) for an electrical plug in the respective coupling region, wherein the cutouts are arranged on opposite end sides (b) of the intermediate housing part, and wherein the intermediate housing part is designed symmetrically in relation to two planes (34), which are provided in the intermediate housing part, for accommodating components.

7. Housing (1) according to one of Claims 1 to 6, **characterized in that** a seal (15, 25) is provided in the coupling region (11, 21, 31, 32) of each housing part (10, 20, 30), so that two seals (15, 25) lie one on the other in the respective coupling region in an assembled state of the housing (1).

8. Housing (1) according to Claim 7, **characterized in that** the seal (15, 25) has a shape which is matched to the coupling region (11, 21, 31, 32) of the respective housing part (10, 20, 30).

## Revendications

1. Boîtier (1) recevant des composants électroniques (2),
le boîtier présentant une première partie et une deuxième partie (10, 20) qui forment une partie supérieure de boîtier et une partie inférieure de boîtier qui présentent chacune une zone d'accouplement (11, 21) et aptes à être accouplées l'une à l'autre par leur zone d'accouplement,
chacune des parties du boîtier présentant une surface de base (G) et formant un espace intérieur (I) conçu pour délimiter de manière compacte les composants lorsqu'elles sont assemblées,
le boîtier présentant des moyens de réception (14a, 24a) permettant de disposer les composants de manière définie,
chaque partie de boîtier étant prévue pour reprendre au moins un composant,
les moyens de réception (14a, 24a) étant prévus dans chaque partie de boîtier,
**caractérisé en ce que**
chaque partie de boîtier présente dans la zone d'accouplement une découpe (13, 23) réalisée dans la paroi extérieure verticale de la partie de boîtier et qui forme avec la zone d'accouplement d'une partie de boîtier voisine un passage de l'intérieur vers l'extérieur pour une fiche lorsque le boîtier est assemblé et
**en ce que** la découpe (13, 23) pour fiche du composant prévu dans la première partie de boîtier (10) est prévue dans la deuxième partie de boîtier (20).

2. Boîtier selon la revendication 1, **caractérisé en ce que** les moyens de réception sont disposés dans un plan (14, 24) de réception des composants et sont prévus au niveau de la surface de base (G) de la partie de boîtier concernée.

3. Boîtier selon l'une des revendications précédentes, dans lequel les parties de boîtier présentent une géométrie adaptée aux composants à reprendre de telle sorte que pour des composants essentiellement rectangulaires, lorsque le boîtier est assemblé, il présente essentiellement la forme d'un parallélépipède présentant deux côtés longitudinaux (a) et deux côtés frontaux (b) ainsi qu'une hauteur spécifique (h),
**caractérisé en ce que**
la découpe formée dans la première partie de boîtier et la découpe formée dans la deuxième partie de boîtier sont disposées sur des côtés frontaux opposés.

4. Boîtier selon l'une des revendications précédentes, **caractérisé en ce que** chacune des parties de boîtier présente deux côtés frontaux dont les surfaces frontales (B) ont des tailles différentes et **en ce que** la découpe est prévue sur le côté frontal (b) qui présente la surface frontale la plus grande.

5. Boîtier selon l'une des revendications 2 à 4 qui précèdent, **caractérisé en ce que** la zone d'accouplement de chaque partie de boîtier est périphérique et s'étend sur les côtés longitudinaux (a) du boîtier parallèlement à la surface de base (G) ou au moins sur une partie de son parcours, obliquement par rapport à la surface de base (G).

6. Boîtier selon l'une des revendications précédentes, **caractérisé en ce que** la première et la deuxième partie de boîtier sont configurées en forme de coquille et **en ce que** le boîtier présente une troisième partie (30) qui présente la forme d'une partie de boîtier intermédiaire présentant deux zones d'accouplement opposées (31, 32) et disposées à l'état monté entre la première et la deuxième partie de boîtier, et qui présentent dans la zone d'accouplement concernée une découpe (33a, 33b) pour une fiche électrique, les découpes étant disposées sur des côtés frontaux opposés (b) de la partie de boîtier intermédiaire, la partie de boîtier intermédiaire étant symétrique par rapport à deux plans (34) prévus pour la réception des composants dans la partie intermédiaire de boîtier.

7. Boîtier (1) selon l'une des revendications 1 à 6, **caractérisé en ce qu'**un joint d'étanchéité (15, 25) est prévu dans la zone d'accouplement (11, 21, 31, 32) de chaque partie de boîtier (10, 20, 30) de telle sorte que lorsque le boîtier (1) est assemblé, deux joints d'étanchéité (15, 25) soient posés l'un sur l'autre dans la zone d'accouplement concernée.

8. Boîtier (1) selon la revendication 7, **caractérisé en ce que** le joint d'étanchéité (15, 25) présente une forme adaptée à la zone d'accouplement (11, 21, 31, 32) de chaque partie de boîtier (10, 20, 30).
